# EUROPÄISCHE PATENTSCHRIFT

(11) **EP 2 936 548 B1**
(45) Veröffentlichungstag und Bekanntmachung des Hinweises auf die Patenterteilung: **06.06.2018**
(21) Anmeldenummer: 13802971.5
(22) Anmeldetag: 11.12.2013
(51) Int. Cl.: H01L 21/02, H01L 21/36

(54) **VERFAHREN ZUR HERSTELLUNG EINES VERBINDUNGSHALBLEITERS SOWIE DÜNNSCHICHTSOLARZELLE**
METHOD FOR MANUFACTURING A COMPOUND SEMICONDUCTOR AND THIN FILM SOLAR CELL
PROCÉDÉ DESTINÉ À LA FABRICATION D'UN SEMI-CONDUCTEUR COMPOSÉ ET CELLULE SOLAIRE EN COUCHES MINCES

(30) Priorität: 20.12.2012 EP 12198612
(43) Veröffentlichungstag der Anmeldung: 28.10.2015
(73) Patentinhaber: Saint-Gobain Glass France, 92400 Courbevoie (FR)
(72) Erfinder: JOST, Stefan, 81543 München (DE); LECHNER, Robert, 81377 München (DE); DALIBOR, Thomas, 82211 Herrsching am Ammersee (DE); ERAERDS, Patrick, 85591 Vaterstetten (DE)
(74) Vertreter: Gebauer, Dieter Edmund
(86) Internationale Anmeldenummer: PCT/EP2013/076158
(87) Internationale Veröffentlichungsnummer: WO 2014/095503

(56) Entgegenhaltungen:
- WO-A2-2011/028957
- DE-A1-102009 053 532
- US-A1- 2012 003 786
- NAKADA T ET AL: "THIN FILMS OF CuInSe2 PRODUCED BY THERMAL ANNEALING OF MULTILAYERS WITH ULTRA-THIN STACKED ELEMENTAL LAYERS", 10TH. E.C. PHOTOVOLTAIC SOLAR ENERGY CONFERENCE. LISBON, PORTUGAL, APRIL 8 - 12, 1991; [PROCEEDINGS OF THE INTERNATIONAL PHOTOVOLTAIC SOLAR ENERGY CONFERENCE], DORDRECHT, KLUWER ACADEMIC PUBLISHERS, NL, Bd. CONF. 10, 8. April 1991 (1991-04-08), Seiten 887-890, XP001135837, ISBN: 978-0-7923-1389-2

## Beschreibung

Die Erfindung liegt auf dem technischen Gebiet der Herstellung von Dünnschichtsolarzellen und betrifft ein Verfahren zur Herstellung eines Chalkopyrit-Verbindungshalbleiters sowie eine Dünnschichtsolarzelle mit einem aus einem quaternären Verbindungshalbleiter Cu(In,Ga)S₂, einem quaternären Verbindungshalbleiter Cu(In,Ga)Se₂ oder einem pentanären Verbindungshalbleiter Cu(In,Ga)(S,Se)₂ bestehenden Absorber.

Dünnschichtsysteme für Solarzellen und Solarmodule sind hinreichend bekannt und in verschiedenen Ausführungen, je nach Substrat und aufgebrachten Materialien, auf dem Markt vorhanden. Die Materialien werden so gewählt, dass das einfallende Sonnenspektrum maximal ausgenutzt wird. Aufgrund der physikalischen Eigenschaften und der technologischen Handhabbarkeit sind Dünnschichtsysteme mit amorphem, mikromorphem oder polykristallinen Silizium, Cadmium-Tellurid (CdTe), Gallium-Arsenid (GaAs), Kupfer-Indium-Gallium-Selenid (Cu(In,Ga)Se₂), Kupfer-Indium-Gallium-Sulfid (Cu(In,Ga)S₂), Kupfer-Indium-Gallium-Selenid-Sulfid (Cu(In,Ga)(S,Se)₂), Kupfer-Zink-Zinn-Sulfo-Selenid (CZTS aus der Gruppe der Kesterite) sowie organischen Halbleitern besonders für Solarzellen geeignet. Der pentenäre Halbleiter Cu(In,Ga)(S,Se)₂ und die quaternären Halbleiter Cu(In,Ga)Se₂ und Cu(In,Ga)S₂ gehören zur Gruppe der Chalkopyrit-Verbindungshalbleiter und werden häufig mit CIS (Kupferindiumdiselenid oder -sulfid) oder CIGS (Kupferindiumgalliumdiselenid, Kupferindiumgalliumdisulfid oder Kupferindiumgalliumdisulfoselenid) abgekürzt. S kann in der Abkürzung für Selen, Schwefel oder eine Mischung beider Chalkogene stehen.

In der Literatur sind verschiedene Verfahren zur Herstellung von Chalkopyrit-Verbindungshalbleitern beschrieben: So wird beispielsweise die Koverdampfung der Halbleiterkomponenten auf ein Substrat in einem einstufigen Verfahren eingesetzt, wie aus DE 10024882 A1 und DE 102005040087 A1 bekannt ist.

Ein alternatives Verfahren zur Herstellung von Chalkopyrit-Verbindungshalbleitern besteht aus einem Zweistufenprozess. Solche zweistufigen Verfahren sind beispielsweise aus J. Palm et al., "CIS module pilot processing applying concurrent rapid selenization and sulfurization of large area thin film precursors", Thin Solid Films 431-432, S. 414-522 (2003) bekannt. Dabei wird zunächst eine Rückelektrode aus Molybdän auf ein Substrat, beispielsweise ein Glassubstrat, aufgebracht. Die Molybdänschicht wird beispielsweise mit einem Laser strukturiert. Anschließend werden auf die Molybdänschicht verschiedene Precursor-Schichten aus Kupfer, Indium und Gallium abgeschieden, beispielsweise durch Magnetron-Sputtern. Außerdem wird eine Selen-Schicht und/oder eine Schwefel-Schicht durch thermisches Verdampfen auf der Schichtfolge abgeschieden. Die so entstandene Schichtstruktur mit den Precursor-Schichten wird in einem zweiten Prozess wärmebehandelt. Durch die Wärmebehandlung erfolgt die eigentliche Kristallbildung und Phasenumwandlung der Precursor-Schichten zur eigentlichen Halbleiterschicht.

Demgegenüber besteht die Aufgabe der vorliegenden Erfindung darin, im Stand der Technik bekannte Verfahren zur Herstellung von Chalkopyrit-Verbindungshalbleitern und entsprechende Dünnschichtsolarzellen mit Verbindungshalbleitern in vorteilhafter Weise weiterzubilden.

Diese und weitere Aufgaben werden nach dem Vorschlag der Erfindung durch ein Verfahren zur Herstellung eines Verbindungshalbleiters, durch einen Verbindungshalbleiter sowie eine Dünnschichtsolarzelle mit den Merkmalen der nebengeordneten Patentansprüche gelöst. Vorteilhafte Ausgestaltungen der Erfindung sind durch die Merkmale der Unteransprüche angegeben.

Erfindungsgemäß ist ein Verfahren zur Herstellung eines Chalkopyrit-Verbindungshalbleiters gezeigt, welches vorzugsweise Teil eines Verfahrens zur Herstellung einer Dünnschichtsolarzelle beziehungsweise eines Dünnschichtsolarmoduls ist. Mit dem Begriff "Dünnschichtsolarzelle" werden hier und im Weiteren photovoltaische Schichtsysteme mit Dicken von nur wenigen Mikrometern bezeichnet. Solche Schichtsysteme benötigen Trägersubstrate zur Bereitstellung einer ausreichenden mechanischen Festigkeit. Bekannte Trägersubstrate für Dünnschichtsolarzellen enthalten anorganisches Glas, Polymere oder Metalllegierungen und können in Abhängigkeit von Schichtdicke und Materialeigenschaften als starre Platten oder biegsame Folien ausgestaltet sein.

Das erfindungsgemäße Verfahren umfasst die folgenden Schritte:
Einen Schritt zum Erzeugen zumindest eines Precursor-Schichtstapels, bestehend aus einer ersten Precursor-Schicht, einer zweiten Precursor-Schicht und einer dritten Precursor-Schicht in drei Stufen: Dabei wird in einer ersten Stufe die erste Precursor-Schicht hergestellt durch Abscheiden der Metalle Kupfer (Cu), Indium (In) und Gallium (Ga) auf einen Körper. In einer zweiten Stufe wird die zweite Precursor-Schicht hergestellt durch Abscheiden zumindest eines Chalkogens, gewählt aus Schwefel (S) und Selen (Se), auf der ersten Precursor-Schicht. In einer dritten Stufe wird die dritte Precursor-Schicht hergestellt durch Abscheiden der Metalle Kupfer (Cu), Indium (In) und Gallium (Ga), auf der zweiten Precursor-Schicht.

Einen weiteren Schritt zum Wärmebehandeln des zumindest einen Precursor-Schichtstapels in einem Prozessraum während eines ersten Zeitintervalls derart, dass die Metalle der ersten Precursor-Schicht, das zumindest eine Chalkogen der zweiten Precursor-Schicht und die Metalle der dritten Precursor-Schicht zum pentanären Verbindungshalbleiter Cu(In,Ga)(S,Se)₂ zum quaternären Verbindungshalbleiter Cu(In,Ga)Se₂ oder zum quaternären Verbindungshalbleiter Cu(In,Ga)S₂ reaktiv umgesetzt werden. Die Schreibweise "Cu(In,Ga)(S,Se)₂" bedeutet hier, dass die Chalkogene Schwefel (S) und Selen (Se) in Kombination im Verbindungshalbleiter enthalten sind. Gleiches gilt für die beiden Metalle Indium (In) und Gallium (Ga).

In eine vorteilhaften Weiterbildung des erfindungsgemäßen Verfahrens erfolgt die Wärmebehandlung des zumindest einen Precursor-Schichtstapels in einer Prozessgasatmosphäre, die zumindest zeitweilig zumindest ein Chalkogen, nämlich Schwefel (S) und/oder Selen (Se), oder zumindest eine chalkogenhaltige Verbindung, in denen Schwefel und/oder Selen in gebundener Form enthalten ist, enthält. Zu diesem Zweck werden ein oder mehrere Prozessgase, enthaltend mindestens ein elementares Chalkogen, gewählt aus Schwefel und Selen, und/oder zumindest eine chalkogenhaltige Verbindung, in denen Schwefel und/oder Selen in gebundener Form enthalten ist, beispielsweise Schwefelwasserstoff (H₂S) oder Selenwasserstoff (H₂Se) oder andere schwefel- beziehungsweise selenhaltige Gase, zumindest zeitweilig während der Wärmebehandlung des zumindest einen Precursor-Schichtstapels dem Prozessraum zugeführt.

Das zumindest eine Prozessgas kann ununterbrochen während des ersten Zeitintervalls der Wärmebehandlung oder aber nur während zumindest eines zweiten Zeitintervalls, welcher kürzer als das erste Zeitintervall ist, dem Prozessraum zugeführt werden. Beispielsweise kann das zumindest eine Prozessgas in einer früheren und/oder einer späteren Phase der Wärmebehandlung in den Prozessraum eingespeist werden. Insbesondere ist es im erfindungsgemäßen Verfahren möglich, dass das zumindest eine Prozessgas so zugeführt wird, dass sich die Zusammensetzung der chalkogenhaltigen Atmosphäre im Prozessraum während der Wärmebehandlung ändert, um auf diese Weise gezielt Einfluss auf die Zusammensetzung des erzeugten Verbindungshalbleiters zu nehmen.

Vorteilhafterweise hat der Körper beim Abscheiden der zweiten Precursor-Schicht eine Temperatur von weniger als 150°C, stärker bevorzugt weniger als 100°C, wodurch eine unbeabsichtigte (Teil-)Reaktion schon beim Abscheiden der Precursor-Materialien zuverlässig verhindert werden kann. Sowohl beim Abscheiden der Metalle Kupfer, Indium und Gallium als auch beim Abscheiden des zumindest einen Chalkogens können ein oder mehrere Dotierstoffe (beispielsweise Natrium oder Kalium) abgeschieden werden. Gleiches gilt für die Abscheidung der dritten Precursor-Schicht auf der zweiten Precursor-Schicht. Zusätzlich kann die Dotierstoffzugabe auch als eine weitere Precursor-Schicht erfolgen.

Um auf die Kristallqualität des erzeugten Verbindungshalbleiters und insbesondere den Wirkungsgrad der Dünnschichtsolarzelle Einfluss zu nehmen, kann es von Vorteil sein, wenn zum Abscheiden der ersten Precursor-Schicht ein Lagenstapel aus Einzellagen der Metalle Kupfer, Indium und Gallium (wobei jede Einzellage aus einem einzigen Metall besteht) mehrmals nacheinander abgeschieden wird. Zu diesem Zweck kann es weiterhin von Vorteil sein, wenn zum Abscheiden der zweiten Precursor-Schicht ein Lagenstapel aus Einzellagen der Chalkogene Schwefel und Selen (wobei jede Einzellage aus einem einzigen Chalkogen besteht) mehrmals nacheinander abgeschieden wird. Gleichermaßen kann es im Hinblick auf die Kristallqualität von Vorteil sein, wenn der Precursor-Schichtstapel mehrmals nacheinander abgeschieden wird.

Sollen durch das erfindungsgemäße Verfahren die quaternären Verbindungshalbleiter Cu(In,Ga)Se₂ oder Cu(In,Ga)S₂ hergestellt werden, ist es von Vorteil, wenn die zweite Precursor-Schicht hergestellt wird durch Abscheiden eines Chalkogens, gewählt aus Schwefel und Selen, auf der ersten Precursor-Schicht, wobei in dem zumindest einen, zumindest zeitweilig während der Wärmebehandlung zugeführten Prozessgas
- das gleiche Chalkogen, gewählt aus Schwefel und Selen, wie in der zweiten Precursor-Schicht, und/oder
- eine chalkogenhaltige Verbindung, gewählt aus einer schwefelhaltigen Verbindung und einer selenhaltigen Verbindung, mit dem gleichen Chalkogen wie in der zweiten Precursor-Schicht enthalten ist.

Soll der pentanäre Verbindungshalbleiter Cu(In,Ga)(S,Se)₂ hergestellt werden, ist es von Vorteil wenn die zweite Precursor-Schicht hergestellt wird durch Abscheiden eines Chalkogens, gewählt aus Schwefel und Selen, auf der ersten Precursor-Schicht, wobei in dem zumindest einen, zumindest zeitweilig während der Wärmebehandlung zugeführten Prozessgas das jeweils andere Chalkogen, gewählt aus Schwefel und Selen, wie in der zweiten Precursor-Schicht und/oder eine chalkogenhaltige Verbindung, gewählt aus einer schwefelhaltigen Verbindung und einer selenhaltigen Verbindung, mit dem jeweils anderen Chalkogen wie in der zweiten Precursor-Schicht enthalten ist.

Andererseits kann es zur Herstellung des pentanären Verbindungshalbleiters Cu(In,Ga)(S,Se)₂ von Vorteil sein, wenn die zweite Precursor-Schicht hergestellt wird durch Abscheiden der beiden Chalkogene Schwefel und Selen auf der ersten Precursor-Schicht, wobei in dem zumindest einen, zumindest zeitweilig während der Wärmebehandlung zugeführten Prozessgas Schwefel und/oder Selen und/oder eine schwefelhaltigen Verbindung und/oder eine selenhaltige Verbindung enthalten ist.

Durch den erfindungsgemäßen Schichtaufbau wird bei der Herstellung der quaternären Verbindungshalbleiter Cu(In,Ga)Se₂ oder Cu(In,Ga)S₂, oder des pentanären Verbindungshalbleiters Cu(In,Ga)(S,Se)₂ ein definierbares beziehungsweise definiertes Gallium-Tiefenprofil ausgebildet. Insbesondere kann das Gallium-Tiefenprofil von einer Oberfläche des Verbindungshalbleiters hin zu einer Grenzfläche zum Körper so ausgebildet werden, dass der Galliumgehalt an der Oberfläche des Verbindungshalbleiters einen ersten Maximalwert hat, zur Körpergrenzfläche hin bis zu einem Minimalwert abnimmt und anschließend wieder zunimmt, und an der Körpergrenzfläche einen zweiten Maximalwert hat.

Galliumgehalt bedeutet im Rahmen der vorliegenden Erfindung das atomare Verhältnis von Gallium bezogen auf den summarischen Gehalt an Indium und Gallium, das heißt Ga/(In+Ga).

Ein erhöhter Galliumgehalt im Chalkopyrit-Verbindungshalbleiter führt zu einer lokalen Erhöhung der Bandlücke. Bei einer Verwendung des Verbindungshalbleiters als Absorber einer Dünnschichtsolarzelle führt die Erhöhung der Bandlücke an der Grenzfläche zur Rückelektrode und an der Oberfläche zu einer vorteilhaften Erhöhung der Leerlaufspannung.

Vorzugsweise wird das Gallium-Tiefenprofil dabei so ausgebildet, dass eine absolute Änderung des Galliumgehalts zumindest über einen Teilbereich des Tiefenprofils, das heißt über zumindest einen Teilbereich der Schichtdicke des Verbindungshalbleiters, insbesondere von der Halbleiteroberfläche bis zur Körpergrenzfläche, wenigstens 10%, wenigstens 20%, wenigstens 30%, wenigstens 40%, wenigstens 50%, wenigstens 60%, wenigstens 70% oder wenigstens 80% beträgt. Besonders bevorzugt beträgt die relative Änderung des Galliumgehalts wenigstens 20%.

Die Erfindung zeigt damit ein neuartiges Verfahren zur Herstellung von Verbindungshalbleitern mit einem Doppelmaximum im Galliumgehalt, wobei ein Maximum an der Grenzfläche zum Körper und ein zweites Maximum an der Halbleiteroberfläche angeordnet ist, in einem Zweistufenverfahren.

In Zweistufenverfahren zur Herstellung von Chalkopyrit-Verbindungshalbleitern nach dem Stand der Technik werden lediglich zwei Precursor-Schichten verwendet. Diese sind eine metallische erste Precursor-Schicht, die auf der Rückelektrode angeordnet ist und eine zweite, chalkogenhaltige Precursor-Schicht, die auf der ersten Precursor-Schicht angeordnet ist. Um die gewünschte Chalkogenisierung des Verbindungshalbleiters zu erhalten kann ein Selenüberschuss eingesetzt werden. Das bedeutet, dass das atomare Verhältnis von aufgebrachten Chalkogenen größer ist als die Summe der Metalle Kupfer, Indium und Gallium. Des Weiteren wird häufig eine Prozessbox eingesetzt, die den Prozessraum um den Precursor-Schichtstapel begrenzt und Chalkogen-Verluste während der anschließenden Wärmebehandlung minimiert.

Der erfindungsgemäße Schichtaufbau, bei dem die Chalkogen-Komponente in der zweiten Precursor-Schicht angeordnet ist und durch eine dritte metallische Precursor-Schicht abgedeckt wird, hat dagegen mehrere prozesstechnische Vorteile: Die Bindung des Chalkogens an den metallischen Precursor ist besonders effektiv, so dass auf den aus dem Stand der Technik bekannten Chalkogenüberschuss und/oder auf die Reduzierung des Prozessraum durch eine Prozessbox unter Umständen verzichtet werden kann. Alternativ oder in Kombination kann auf die zusätzliche Zuführung eines chalkogenhaltigen Prozessgases während der Wärmebehandlung vollständig oder teilweise verzichtet werden.

In einer vorteilhaften Ausführungsform des erfindungsgemäßen Verfahrens wird auf der dritten Precursor-Schicht eine vierte Precursor-Schicht angeordnet, die zumindest ein Chalkogen, gewählt aus Schwefel und Selen, enthält. Die vierte Precursor-Schicht ist bevorzugt dünner als die zweite Precursor-Schicht ausgestaltet.

Dies hat den besonderen Vorteil, dass beispielsweise bei einer zweiten Precursor-Schicht aus Se und einer vierten Precursor-Schicht aus Se, der Einbau von S aus einem H₂S-haltigen Prozessgas in den Verbindungshalbleiter besonders gut kontrollierbar ist. Außerdem kann durch die zusätzliche, obenliegende vierte Precursor-Schicht die Kristallqualität des erzeugten Verbindungshalbleiters zusätzlich verbessert werden.

Von besonderem Vorteil ist es, wenn bei der Herstellung des pentanären Verbindungshalbleiters Cu(In,Ga)(S,Se)₂ durch das zumindest eine Prozessgas ein definierbares beziehungsweise definiertes Schwefel-Tiefenprofil ausgebildet wird. Insbesondere kann das Schwefel-Tiefenprofil von einer Oberfläche des Verbindungshalbleiters hin zu einer Grenzfläche zum Körper so ausgebildet werden, dass
- der Schwefelgehalt an der Halbleiteroberfläche einen Maximalwert hat, zur Körpergrenzfläche hin abnimmt und an der Körpergrenzfläche einen Minimalwert hat; oder
- der Schwefelgehalt an der Halbleiteroberfläche einen Minimalwert hat, zur Körpergrenzfläche hin zunimmt und an der Körpergrenzfläche einen Maximalwert hat; oder
- der Schwefelgehalt an der Halbleiteroberfläche einen ersten Maximalwert hat, zur Körpergrenzfläche hin bis zu einem Minimalwert abnimmt und anschließend wieder zunimmt, und an der Körpergrenzfläche einen zweiten Maximalwert hat; oder
- der Schwefelgehalt an der Halbleiteroberfläche einen ersten Minimalwert hat, zur Körpergrenzfläche hin bis zu einem Maximalwert zunimmt und anschließend wieder abnimmt, und an der Körpergrenzfläche einen zweiten Minimalwert hat.

Schwefelgehalt bedeutet im Rahmen der vorliegenden Erfindung das atomare Verhältnis von Schwefel bezogen auf den summarischen Gehalt an Selen und Schwefel, das heißt S/(Se+S) .

Vorzugsweise wird das Schwefel-Tiefenprofil dabei so ausgebildet, dass eine absolute Änderung des Schwefelgehalts zumindest über einen Teilbereich des Tiefenprofils, das heißt über zumindest einen Teilbereich der Schichtdicke des Verbindungshalbleiters, insbesondere von der Halbleiteroberfläche bis zur Körpergrenzfläche, wenigstens 10%, wenigstens 20%, wenigstens 30%, wenigstens 40%, wenigstens 50%, wenigstens 60%, wenigstens 70% oder wenigstens 80% beträgt. Besonders bevorzugt beträgt die relative Änderung des Schwefelgehalts wenigstens 20%.

Somit ist es durch das erfindungsgemäße Verfahren möglich, bei der Wärmebehandlung gezielt Einfluss auf die Zusammensetzung des pentanären Verbindungshalbleiters Cu(In,Ga) (Se,S)₂ bezüglich des Schwefelgehalts (bezogen auf den summarischen Gehalt an Selen und Schwefel, das heißt S/(Se+S)) zu nehmen. Mit anderen Worten kann durch eine thermische Prozessierung in einer zeitlich und in der Konzentration an Schwefel und/oder Selen veränderbaren chalkogenhaltigen Prozessatmosphäre die Zusammensetzung des Halbleiters über die Schichtdicke und damit dessen Bandlücke und Bandlückenprofil beeinflusst werden. Dabei ist es insbesondere möglich, Verbindungshalbleiter mit einer homogenen Zusammensetzung bezüglich des Schwefelgehalts herzustellen, in denen der Schwefelgehalt über die Schichtdicke unverändert ist.

In besonders vorteilhafter Weise kann ein pentanärer Verbindungshalbleiter mit einem definierten (vorbestimmten) beziehungsweise definierbarem (vorbestimmbaren) Schwefel-Tiefenprofil (S/(Se+S)) hergestellt werden, dessen Schwefelgehalt (bezogen auf den summarischen Gehalt an Selen und Schwefel) über die Schichtdicke variiert. Ohne an eine besondere Theorie gebunden zu sein, wird hierdurch eine Steigerung des Wirkungsgrads einer Dünnschichtsolarzelle erwartet, deren Absorber aus dem Verbindungshalbleiter besteht.

Beispielsweise kann ein Schwefel-Tiefenprofil mit einem maximalen Wert des Verhältnisses S/(Se+S) an der Oberfläche des Absorbers und abnehmendem Wert des Verhältnisses S/(Se+S) zur Grenzfläche eingestellt werden. Die dadurch erhöhte Bandlücke an der Absorberoberfläche führt in der Dünnschichtsolarzelle zu einer Erhöhung der Leerlaufspannung.

Andererseits wird die Höhe des Kurzschlussstroms bestimmt durch das Minimum der Bandlücke im Absorberinneren. Dies kann ebenfalls durch ein Schwefel-Tiefenprofil mit einem maximalen Wert des Verhältnisses S/(Se+S) an der Oberfläche des Absorbers und abnehmendem Wert des Verhältnisses S/(Se+S) zur Grenzfläche eingestellt werden.

In Kombination mit dem eingestellten Gallium-Tiefenprofil führt das eingestellte Schwefel-Tiefenprofil zu einer Erhöhung des Wirkungsgrads der Dünnschichtsolarzelle.

Neben der Einstellung eines Bandlücken-Tiefenprofils besteht die Möglichkeit zur Erhöhung des Wirkungsgrades der Dünnschichtsolarzelle durch eine Verbesserung der Kristallqualität der Halbleiterschicht. Beispielsweise ist aus Untersuchungen am Materialsystem Cu-In-Ga-Se-S bekannt, dass die verschiedenen Metalle eine unterschiedliche Reaktionskinetik mit verschiedenen Chalkogenen aufweisen. Dies führt zu deutlichen Unterschieden in der Bildungstemperatur der verschiedenen Metall-Chalkogenidphasen und kann damit die Kristallqualität des Cu(In,Ga)(S,Se)₂-Verbindungshalbleiters negativ beeinflussen. Insbesondere kann angenommen werden, dass durch eine geänderte Chalkogengasatmosphäre (Se/S Zusammensetzung) im Heizprozess Einfluss auf die Chalkogenisierung der Cu-In-Ga Precursor-Schichten genommen werden kann. Somit können Unterschiede in der Chalkogenisierungskinetik durch eine zeitlich veränderte Prozessgasatmosphäre (Se/S Zusammensetzung) ausgeglichen werden. Es wird erwartet, dass dadurch die Kristallqualität und der Wirkungsgrad positiv beeinflusst werden können.

In dem erfindungsgemäßen Verfahren kann die erste Precursor-Schicht und die dritte Precursor-Schicht grundsätzlich so ausgebildet werden, dass
- der Kupfergehalt kleiner ist als der summarische Gehalt an Indium und Gallium, oder
- der Kupfergehalt zum summarischen Gehalt an Indium und Gallium gleich ist, oder
- der Kupfergehalt größer ist als der summarische Gehalt an Indium und Gallium.

Kupfergehalt bedeutet im Rahmen der vorliegenden Erfindung das atomare Verhältnis von Kupfer bezogen auf den summarischen Gehalt an Indium und Gallium, das heißt Cu/(In+Ga).

Andererseits kann die erste Precursor-Schicht grundsätzlich so ausgebildet werden, dass
- der Indiumgehalt kleiner ist als der Galliumgehalt, oder
- der Indiumgehalt zum Galliumgehalt gleich ist, oder
- der Indiumgehalt größer ist als der Galliumgehalt.

Indiumgehalt bedeutet im Rahmen der vorliegenden Erfindung das atomare Verhältnis von Indium bezogen auf den summarischen Gehalt an Indium und Gallium, das heißt In/(In+Ga).

Besonders vorteilhaft wird die erste Precursor-Schicht so ausgebildet, dass der Kupfergehalt kleiner ist als der summarische Gehalt an Indium und Gallium und zugleich der Galliumgehalt kleiner ist als der Indiumgehalt, wobei angenommen wird, dass durch diese Maßnahme ein günstiger Einfluss auf die Kristallqualität und den Wirkungsgrad der Dünnschichtsolarzelle erreicht werden kann.

Bei einer weiteren vorteilhaften Ausgestaltung des erfindungsgemäßen Verfahrens werden zur Herstellung des pentanären Verbindungshalbleiters Cu(In,Ga)(S,Se)₂ die drei Precursor-Schichten so ausgebildet, dass das atomare Verhältnis des Gesamtgehalts an Chalkogen(en) zum Gesamtgehalt an Metallen größer oder gleich 1 ist. Auch durch diese Maßnahme kann ein günstiger Einfluss auf die Kristallqualität und den Wirkungsgrad der Dünnschichtsolarzelle erreicht werden.

Die Erfindung erstreckt sich des Weiteren auf eine Dünnschichtsolarzelle mit einem aus einem quaternären Verbindungshalbleiter Cu(In,Ga)Se₂, einem quaternären Verbindungshalbleiter Cu(In,Ga)S₂ oder einem pentanären Verbindungshalbleiter Cu(In,Ga)(S,Se)₂ bestehenden Absorber auf einem Körper, wobei der Absorber von einer Halbleiteroberfläche zu einer Körpergrenzfläche hin ein definierbares beziehungsweise definiertes Gallium-Tiefenprofil (bezogen auf einen summarischen Gehalt an Gallium und Indium) aufweist.

Der Verbindungshalbleiter des Absorbers wird vorteilhafterweise durch das wie oben beschriebene Verfahren hergestellt.

In der erfindungsgemäßen Dünnschichtsolarzelle ist das Gallium-Tiefenprofil so ausgebildet, dass der Galliumgehalt an der Oberfläche des Absorbers einen ersten Maximalwert hat, zur Grenzfläche zum Körper und damit zur Rückelektrode hin bis zu einem Minimalwert abnimmt und anschließend wieder zunimmt, und an der Grenzfläche einen zweiten Maximalwert hat.

Ein erhöhter Galliumgehalt im Chalkopyrit-Verbindungshalbleiter führt zu einer lokalen Erhöhung der Bandlücke. Die Erhöhung der Bandlücke an der Grenzfläche zur Rückelektrode und an der Oberfläche führen in der Dünnschichtsolarzelle zu einer vorteilhaften Erhöhung der Leerlaufspannung.

In einer vorteilhaften Weiterbildung des erfindungsgemäßen Absorbers ist das Gallium-Tiefenprofil so ausgebildet, dass eine relative Änderung des Galliumgehalts zumindest über einen Teilbereich des Tiefenprofils wenigstens 10%, wenigstens 20%, wenigstens 30%, wenigstens 40%, wenigstens 50%, wenigstens 60%, wenigstens 70% oder wenigstens 80% beträgt. Änderungen des Galliumgehalts in diesem Bereich sind besonders vorteilhaft für die Leerlaufspannung und den Wirkungsgrad der Dünnschichtsolarzelle.

Bei einer vorteilhaften Ausgestaltung der erfindungsgemäßen Dünnschichtsolarzelle besteht der Absorber aus dem pentanären Verbindungshalbleiter Cu(In,Ga)(S,Se)₂, wobei der Absorber von einer Halbleiteroberfläche zu einer Körpergrenzfläche hin ein definierbares beziehungsweise definiertes Schwefel-Tiefenprofil (bezogen auf einen summarischen Gehalt an Selen und Schwefel) aufweist und das Schwefel-Tiefenprofil so ausgebildet, dass
- der Schwefelgehalt an der Halbleiteroberfläche einen Maximalwert hat, zur Körpergrenzfläche hin abnimmt und an der Körpergrenzfläche einen Minimalwert hat; oder
- der Schwefelgehalt an der Halbleiteroberfläche einen Minimalwert hat, zur Körpergrenzfläche hin zunimmt und an der Körpergrenzfläche einen Maximalwert hat; oder
- der Schwefelgehalt an der Halbleiteroberfläche einen ersten Maximalwert hat, zur Körpergrenzfläche hin bis zu einem Minimalwert abnimmt und anschließend wieder zunimmt, und an der Körpergrenzfläche einen zweiten Maximalwert hat; oder
- der Schwefelgehalt an der Halbleiteroberfläche einen ersten Minimalwert hat, zur Körpergrenzfläche hin bis zu einem Maximalwert zunimmt und anschließend wieder abnimmt, und an der Körpergrenzfläche einen zweiten Minimalwert hat.

Vorzugsweise ist das Schwefel-Tiefenprofil so ausgebildet, dass eine relative Änderung des Schwefelgehalts zumindest über einen Teilbereich des Tiefenprofils, das heißt über zumindest einen Teilbereich der Schichtdicke des Verbindungshalbleiters, insbesondere von der Halbleiteroberfläche bis zur Körpergrenzfläche, wenigstens 10%, wenigstens 20%, wenigstens 30%, wenigstens 40%, wenigstens 50%, wenigstens 60%, wenigstens 70% oder wenigstens 80% beträgt. Besonders bevorzugt beträgt die relative Änderung des Schwefelgehalts wenigstens 20%.

Wie oben bereits erläutert, führt ein erhöhter Galliumgehalt im Chalkopyrit-Verbindungshalbleiter zu einer lokalen Erhöhung der Bandlücke. Bei einer Verwendung des Verbindungshalbleiters als Absorber einer Dünnschichtsolarzelle führt die Erhöhung der Bandlücke an der Grenzfläche zur Rückelektrode und an der Oberfläche zu einer vorteilhaften Erhöhung der Leerlaufspannung. Andererseits wird die Höhe des Kurzschlussstroms durch das Minimum der Bandlücke im Inneren des Absorbers bestimmt. Durch ein Schwefel-Tiefenprofil mit einem Minimum in der Mitte des Absorbers wird die Bandlücke im Innern des Absorbers verkleinert, wodurch sich dich Kurzschlussstromstärke erhöht. In Kombination mit dem eingestellten Gallium-Tiefenprofil führt ein derartiges Schwefel-Tiefenprofil zu einer optimierten Anpassung des Bandverlaufs hin zur Oberfläche (und damit zur Pufferschicht) und hin zur Grenzfläche (und damit zur Rückelektrode) und somit zu einer besonders vorteilhaften Erhöhung des Wirkungsgrads der Dünnschichtsolarzelle.

Ein weiterer Aspekt der Erfindung erstreckt sich auf die Verwendung eines wie oben beschriebenen Verfahrens zum Herstellen eines Chalkopyrit-Verbindungshalbleiters vom Typ Cu(In,Ga)Se₂, Cu(In,Ga)S₂ oder Cu(In,Ga)(S,Se)₂ zur Herstellung des Absorbers einer Dünnschichtsolarzelle oder eines Dünnschichtsolarmoduls.

Es versteht sich, dass die verschiedenen Ausgestaltungen der Erfindung einzeln oder in beliebigen Kombinationen realisiert sein können. Insbesondere sind die vorstehend genannten und nachstehend zu erläuternden Merkmale nicht nur in den angegebenen Kombinationen, sondern auch in anderen Kombinationen oder in Alleinstellung einsetzbar, ohne den Rahmen der vorliegenden Erfindung zu verlassen.

Die Erfindung wird nun anhand von Ausführungsbeispielen näher erläutert, wobei Bezug auf die beigefügten Figuren genommen wird. Es zeigen in vereinfachter, nicht maßstäblicher Darstellung:
- Fig. 1: Schnittansichten zur Veranschaulichung des allgemeinen Verfahrens zur Herstellung eines erfindungsgemäßen Chalkopyrit-Verbindungshalbleiters,
- Fig. 2A: Schnittansichten zur Veranschaulichung spezifischer Vorgehensweisen zur Herstellung des quaternären Verbindungshalbleiters Cu(In,Ga)Se₂,
- Fig. 2B: Schnittansicht des quaternären Verbindungshalbleiters Cu(In,Ga)Se₂ mit Gallium-Tiefenprofil entlang des Absorbers,
- Fig. 3A: Schnittansichten zur Veranschaulichung spezifischer Vorgehensweisen zur Herstellung des pentanären Verbindungshalbleiters Cu(In,Ga)(S,Se)₂,
- Fig. 3B: eine Schnittansicht des pentanären Verbindungshalbleiters Cu(In,Ga)(S,Se)₂ mit Gallium-Tiefenprofil und Schwefel-Tiefenprofil entlang des Absorbers,
- Fig. 3C: eine Schnittansicht eines alternativen pentanären Verbindungshalbleiters Cu(In,Ga)(S,Se)₂ mit Gallium-Tiefenprofil und Schwefel-Tiefenprofil entlang des Absorbers,
- Fig. 4A: Schnittansichten zur Veranschaulichung spezifischer Vorgehensweisen zur Herstellung eines alternativen pentanären Verbindungshalbleiters Cu(In,Ga)(S,Se)₂,
- Fig. 4B: eine Schnittansicht des pentanären Verbindungshalbleiters Cu(In,Ga)(S,Se)₂ mit Gallium-Tiefenprofil und Schwefel-Tiefenprofil entlang des Absorbers,
- Fig. 5A: Schnittansichten zur Veranschaulichung spezifischer Vorgehensweisen zur Herstellung eines alternativen pentanären Verbindungshalbleiters Cu(In,Ga)(S,Se)₂,
- Fig. 5B: eine Schnittansicht des pentanären Verbindungshalbleiters Cu(In,Ga)(S,Se)₂ mit Gallium-Tiefenprofil entlang des Absorbers,
- Fig. 6: eine Schnittansicht einer erfindungsgemäßen Dünnschichtsolarzelle,
- Fig. 7: ein Ausführungsbeispiel der erfindungsgemäßen Verfahrensschritte anhand eines Flussdiagramms,
- Fig. 8: ein Diagramm des Tiefenprofils des Gallium- und Indiumgehalts eines erfindungsgemäßen Absorbers mit Vergleichsbeispielen.

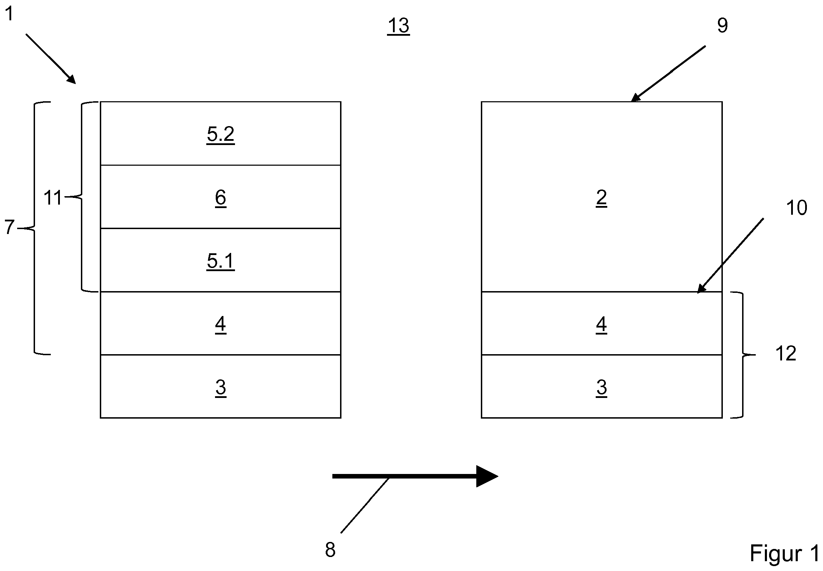

Figur 1 zeigt schematische Schnittansichten eines allgemeinen Verfahrens zur Herstellung einer lichtabsorbierenden Verbindungshalbleiterschicht, im Folgenden Absorber 2 genannt, in einer insgesamt mit der Bezugszahl 1 bezeichneten Schichtstruktur einer Dünnschichtsolarzelle. Es versteht sich, dass die Schichtstruktur 1 zur Herstellung einer Vielzahl Dünnschichtsolarzellen dienen kann, welche in großflächiger Anordnung in monolithisch integrierter Weise seriell miteinander verschaltet sind.

Die Schichtstruktur 1 weist hier eine Substratkonfiguration auf, bei der auf einem (Träger-)Substrat 3 ein aus einer Mehrzahl dünner Schichten bestehender Schichtaufbau 7 aufgebracht ist. Das Substrat 3 besteht hier beispielsweise aus anorganischem Glas, wobei gleichermaßen andere isolierende Materialien mit genügender Festigkeit, sowie inertem Verhalten gegenüber den bei der Herstellung der Dünnschichtsolarzelle durchgeführten Prozessschritten eingesetzt werden können. Weitere Beispiele dafür sind Kunststoffe, insbesondere Polymere oder Metalle, insbesondere Metall-Legierungen. In Abhängigkeit der Schichtdicke und den spezifischen Materialeigenschaften kann das Substrat 3 als starre Platte oder biegsame Folie ausgestaltet sein. Im vorliegenden Ausführungsbeispiel beträgt die Schichtdicke des Substrats 3 beispielsweise 1 bis 5 mm.

Der auf dem Substrat 3 aufgebrachte Schichtaufbau 7 umfasst eine Rückelektrodenschicht 4, die auf einer licht-eintrittsseitigen Oberfläche des Substrats 3 angeordnet ist und beispielsweise aus einem lichtundurchlässigen Metall besteht. Die Rückelektrodenschicht 4 kann beispielsweise durch Aufdampfen oder magnetfeldunterstützte Kathodenzerstäubung (Sputtern) auf dem Substrat 3 abgeschieden werden. Die Rückelektrodenschicht 4 besteht beispielsweise aus Molybdän (Mo), Aluminium (Al), Kupfer (Cu), Titan (Ti) oder aus einem Mehrschichtsystem mit einem solchen Metall, beispielsweise Molybdän (Mo). Die Schichtdicke der Rückelektrodenschicht 4 ist hier geringer als 1 µm, liegt vorzugsweise im Bereich von 300 nm bis 600 nm und beträgt beispielsweise etwa 500 nm. Die Rückelektrodenschicht 4 dient als Rückseitenkontakt beziehungsweise Rückelektrode der Dünnschichtsolarzelle. Zwischen dem Substrat 3 und der Rückelektrodenschicht 4 kann eine Alkali-Barriere angeordnet sein, welche beispielsweise aus Si₃N₄, SiON oder SiCN besteht. Die Rückelektrode 4 kann ein Mehrschichtsystem sein, bei dem eine Titannitrid-Schicht zwischen beispielsweise einer Kupferschicht und einer Molybdänschicht angeordnet ist. Derartige Rückelektroden aus Mehrschichtsystemen sind beispielsweise aus EP 2 369 634 A2 bekannt. Dies ist in Figur 1 nicht näher dargestellt.

Auf der Rückelektrodenschicht 4 sind nacheinander eine erste Precursor-Schicht 5.1, eine zweite Precursor-Schicht 6 und eine dritte Precursor-Schicht 5.2 angeordnet. Die drei Precursor-Schichten 5.1, 6, 5.2 können durch eine mittels Pfeil 8 angedeutete Wärmebehandlung in den photovoltaisch aktiven Absorber 2 reaktiv umgesetzt werden. Die Schichtdicke des Absorbers 2 liegt beispielsweise im Bereich von 0,5-5 µm und beträgt insbesondere etwa 2 µm.

Die in Figur 1 gezeigte Schichtstruktur 1 stellt ein Zwischenprodukt bei der Herstellung einer Dünnschichtsolarzelle dar. Die weitere Prozessierung der Schichtstruktur 1 ist für das Verständnis der Erfindung nicht erforderlich, so dass nicht näher darauf eingegangen werden muss. Lediglich ergänzend sei angegeben, dass oberhalb des Absorbers 2 eine Frontelektrodenschicht ausgebildet wird, die als Vorderseitenkontakt dient und für Strahlung im sichtbaren Spektralbereich transparent ist ("Fensterschicht"). In der Regel wird für die Frontelektrodenschicht ein dotiertes Metalloxid (TCO = Transparent Conductive Oxide) eingesetzt, beispielsweise n-leitendes, Aluminium (Al)-dotiertes Zinkoxid (ZnO), Bor (B)-dotiertes Zinkoxid (ZnO), oder Gallium (Ga)-dotiertes Zinkoxid (ZnO). Zwischen dem Absorber 2 und der Frontelektrodenschicht wird in der Regel eine dünne Pufferschicht angeordnet, welche beispielsweise aus CdS, InₓS_{y}, (In,Ga,Al)ₓ(S,Se)_{y}, ZnS, Zn(O,S), Zn(Mg,O), gegebenenfalls in Kombination mit intrinsischem i-ZnO, besteht. Durch die Pufferschicht kann eine verbesserte Anpassung der Frontelektrodenschicht an den Absorber 2 hinsichtlich Gitterkonstante und Bandverlauf erreicht werden. Frontelektroden-, Puffer-, Absorber- und Rückelektrodenschicht formen gemeinsam einen Heteroübergang, das heißt eine Abfolge von Schichten entgegen gesetzten Leitungstyps. Die Schichtdicke der Frontelektrodenschicht beträgt beispielsweise etwa 300 nm bis 1500 nm, die der Pufferschicht beispielsweise etwa 50 nm. Zum Schutz vor Umwelteinflüssen kann auf der Frontelektrodenschicht eine beispielsweise aus Polyvinylbutyral (PVB), Ethylenvinylacetat (EVA) oder DNP bestehende Kunststoffschicht (Verkapselungsfolie) aufgebracht sein. Zudem kann eine für Sonnenlicht transparente Deckplatte vorgesehen sein, die beispielsweise aus extraweißem Glas (Frontglas) mit geringem Eisengehalt besteht und eine Dicke von beispielsweise 1 bis 4 mm aufweisen kann.

Der beschriebene Aufbau einer Dünnschichtsolarzelle beziehungsweise eines Dünnschichtsolarmoduls ist dem Fachmann aus im Handel verfügbaren Dünnschichtsolarzellen sowie beispielsweise aus DE 19956735 B4 bekannt.

In der in Figur 1 gezeigten Substratkonfiguration grenzt die Rückelektrodenschicht 4 an das Substrat 3 an. Es versteht sich, dass die Schichtstruktur 1 gleichermaßen über eine Superstratkonfiguration verfügen kann, bei welcher das Substrat 3 transparent und die Frontelektrodenschicht auf einer der Lichteintrittsseite abgewandten Oberfläche des Substrats 3 angeordnet ist.

Wie bereits erwähnt, kann die Schichtstruktur 1 zur Herstellung integriert serienverschalteter Dünnschichtsolarzellen dienen, wobei die Schichtstruktur 1 in an sich bekannter Weise durch verschiedene Strukturierungslinien ("P1" für Rückelektrode, "P2" für Kontakt Frontelektrode/Rückelektrode und "P3" für Trennung der Frontelektrode) strukturiert wird. Alternativ kann ein Aufbau der Dünnschichtsolarzellen mit Frontelektrode und Grid vorgesehen sein.

Das in Figur 1 veranschaulichte Verfahren dient zur Herstellung des Absorbers 2, der aus einer lichtabsorbierenden Dünnschichthalbleiterschicht vom Typ Chalkopyrit-Verbindungshalbleiter besteht. Der Absorber 2 besteht insbesondere aus dem quaternären Verbindungshalbleiter Cu(In,Ga)Se₂, dem quaternären Verbindungshalbleiter Cu(In,Ga)S₂ oder dem pentanären Verbindungshalbleiters Cu(In,Ga)(S,Se)₂.

Die erste Precursor-Schicht 5.1 und die dritte Precursor-Schicht 5.2 besteht aus den Metallen Cu, In und Ga und wird bevorzugt aus rein metallischen Quellen auf die Rückelektrodenschicht 4 beziehungsweise einen (Mehrschicht-)Körper 12, bestehend aus Substrat 3 und Rückelektrodenschicht 4 (sowie gegebenenfalls weiteren Schichten) abgeschieden. Eine Abscheidung der Metalle Cu, In und Ga auf den Körper 12 kann insbesondere durch die im Folgenden genannten Verfahren realisiert werden, wobei optional ein oder mehrere Dotierstoffe wie Na zugeführt werden können. Hierbei handelt es sich typischer Weise um Vakuumbeschichtungsverfahren, in denen ein festes oder flüssiges Material durch Energieeintrag in die Gasphase überführt und auf dem Körper 12 kondensiert wird (PVD = Physical Vapor Deposition).

Beispiele für typische Abscheideverfahren der Metall Cu, In und Ga sind:
- Sputtern der Elemente Cu, In, Ga aus Targets, in denen diese Metalle elementar enthalten sind (Elementtargets). Vorzugsweise weisen die Elementtargets jeweils eine Reinheit von ≥4N, stärker bevorzugt ≥5N, auf.
- Sputtern der Elemente Cu, In, Ga aus Targets, in denen binäre und/oder ternäre Legierungen dieser Metalle enthalten sind (Legierungstargets), beispielsweise CuIn, CuGa, GaIn oder CuInGa und/oder Kombinationen hiervon. Vorzugsweise weisen die Legierungstargets jeweils eine Reinheit von ≥4N, stärker bevorzugt ≥5N, auf. Optional kann zusätzlich aus Elementtargets der Elemente Cu, In, Ga gesputtert werden, um die Zusammensetzung (Stöchiometrie) der ersten Precursor-Schicht 5.1 oder in der dritten Precursor-Schicht 5.2 in gewünschter Weise einzustellen.
- Thermische Verdampfung, Elektronenstrahlverdampfung oder Laser-Materialablation der Elemente Cu, In, Ga aus Quellen, in denen diese Metalle elementar enthalten sind (Elementquellen). Vorzugsweise weisen die Elementquellen jeweils eine Reinheit von ≥4N, stärker bevorzugt ≥5N, auf.
- Thermische Verdampfung, Elektronenstrahlverdampfung oder Laser-Materialablation der Elemente Cu, In, Ga aus Quellen, in denen binäre und/oder ternäre Legierungen dieser Metalle enthalten sind (Legierungsquellen), beispielsweise Cu-In, Cu-Ga, In-Ga oder Cu-In-Ga und/oder Kombinationen hiervon. Vorzugsweise weisen die Legierungsquellen jeweils eine Reinheit von ≥4N, stärker bevorzugt ≥5N, auf. Optional kann zusätzlich aus Elementquellen der Elemente Cu, In, Ga abgeschieden werden, um die Zusammensetzung (Stöchiometrie) der ersten Precursor-Schicht 5.1 oder der dritten Precursor-Schicht 5.2 in gewünschter Weise einzustellen.
- Elektrochemische Abscheidung von Cu, In und Ga, einzeln oder in Legierungen oder in Verbindungen.

Beim Abscheiden der Metalle Cu, In, Ga mittels Elementtargets beziehungsweise Elementquellen umfasst die erste Precursor-Schicht 5.1 und/oder die dritte Precursor-Schicht 5.2 mehrere metallische Einzellagen, wobei jede Einzellage aus Cu, In oder Ga besteht. Beispielsweise können die Einzellagen in der Lagenfolge Cu/In/Ga abgeschieden werden, wobei aber auch andere Lagenfolgen möglich sind. In einer bevorzugten Ausgestaltung wird eine Lagenfolge, bestehend aus Einzellagen der Metalle Cu, In, Ga, beispielsweise Cu/In/Ga, mehrmals nacheinander abgeschieden, so dass die erste Precursor-Schicht 5.1 und/oder die dritte Precursor-Schicht 5.2 aus einem Stapel aus n gleichen oder verschiedenen Lagenfolgen (beispielsweise n x Cu/In/Ga) besteht. Vorzugsweise werden 2 bis 20 Lagenfolgen nacheinander abgeschieden (n = 2 bis 20).

Beim Abscheiden der Metalle Cu, In, Ga mittels Legierungstargets beziehungsweise Legierungsquellen umfasst die erste Precursor-Schicht 5.1 und/oder die dritte Precursor-Schicht 5.2 eine oder mehrere metallische Einzellagen, welche aus einer binären oder ternären Legierung der Elemente Cu, In und/oder Ga besteht. Falls zusätzlich aus Elementtargets beziehungsweise Elementquellen abgeschieden wird, können die Einzellagen auch elementares Cu, In und/oder Ga enthalten. Die metallischen Einzellagen können in einer definierten Lagenfolge abgeschieden werden. In einer bevorzugten Ausgestaltung wird eine Lagenfolge, bestehend aus Einzellagen aus binären oder ternären Legierungen der Metalle Cu, In und/oder Ga (sowie gegebenenfalls elementarem Cu, In und/oder Ga) mehrmals nacheinander abgeschieden, so dass die erste Precursor-Schicht 5.1 und/oder die dritte Precursor-Schicht 5.2 aus einem Stapel aus n gleichen oder verschiedenen Lagenfolgen besteht. Vorzugsweise werden 2 bis 20 Lagenfolgen nacheinander abgeschieden (n = 2 bis 20) .

In der Schichtstruktur 1 kann die erste Precursor-Schicht 5.1 und/oder die dritte Precursor-Schicht 5.2 so ausgebildet werden, dass deren Zusammensetzung
- kupferarm ist, was bedeutet, dass der Kupfergehalt kleiner ist als der summarische Gehalt an In und Ga (Cu/(In+Ga) < 1), oder alternativ
- stöchiometrisch ist, was bedeutet, dass der Kupfergehalt zum summarischen Gehalt an In und Ga gleich ist (Cu/(In+Ga) = 1), oder alternativ
- kupferreich ist, was bedeutet, dass der Kupfergehalt größer ist als der summarische Gehalt an In und Ga (Cu/(In+Ga) > 1).
Alle drei Varianten bezüglich des Kupfergehalts können in dem erfindungsgemäßen Verfahren vorgesehen sein.

Des Weiteren kann in der Schichtstruktur 1 die erste Precursor-Schicht 5.1 und/oder die dritte Precursor-Schicht 5.2 so ausgebildet sein, dass deren Zusammensetzung
- indiumarm ist, was bedeutet, dass der Indiumgehalt kleiner ist der Galliumgehalt (In/Ga < 1), oder alternativ
- stöchiometrisch ist, was bedeutet, dass der Indiumgehalt zum Galliumgehalt gleich ist (In/Ga = 1), oder alternativ
- indiumreich ist, was bedeutet, dass Indiumgehalt größer ist als der Galliumgehalt (In/Ga > 1).
Alle drei Varianten bezüglich des Indiumgehalts können in dem erfindungsgemäßen Verfahren vorgesehen sein. Jede Variante bezüglich des Kupfergehalts kann mit jeder Variante bezüglich des Indiumgehalts kombiniert werden. Hinsichtlich eines besonders guten Wirkungsgrads der Dünnschichtsolarzelle ist es erfindungsgemäß bevorzugt, wenn die erste Precursor-Schicht 5.1 und/oder die dritte Precursor-Schicht 5.2 so ausgebildet ist, dass deren Zusammensetzung kupferarm (Cu/(In+Ga) < 1) und zugleich Indiumreich (In/Ga > 1) ist. Beispielsweise kann der Absorber 2 zu diesem Zweck einen auf die summarischen Gehalte an Indium und Gallium bezogenen Kupfergehalt von 0,8 (Cu/(In+Ga) = 0,8) und einen auf Gallium bezogenen Indiumgehalt von 1,22 (In/Ga = 1,22) aufweisen.

Die zweite Precursor-Schicht 6 wird auf die erste Precursor-Schicht 5.1 abgeschieden. Die zweite Precursor-Schicht 6 besteht aus zumindest einem Chalkogen, nämlich S und/oder Se. Das zumindest eine Chalkogen wird ohne metallische Komponenten abgeschieden. Vorzugsweise ist die Temperatur des Substrats 3 beim Abscheiden des zumindest einen Chalkogens niedriger als 150°C, besonders bevorzugt niedriger als 100°C, wodurch in vorteilhafter Weise ein bereits einsetzende Teilreaktion der Metalle der ersten Precursor-Schicht 5.1 mit dem zumindest einen Chalkogen der zweiten Precursor-Schicht 6 verhindert werden kann.

Die Abscheidung von S und/oder Se kann beispielsweise durch die im Folgenden genannten Verfahren realisiert werden, wobei bei allen Verfahren ein oder mehrere Dotierstoffe wie Na optional zuführt werden können:
- Thermische Verdampfung von S und/oder Se (sequentiell oder simultan) aus ein oder zwei Verdampfungsquellen, optional mit Dotierstoffzugabe wie Na durch Verdampfung des Dotierstoffes oder einer dotierstoffhaltigen Verbindung.
- Sputtern aus Targets, in denen das jeweilige Chalkogen (S oder Se) elementar enthalten ist (Elementtargets).

Die drei Precursor-Schichten 5.1, 6, 5.2 bilden gemeinsam einen Precursor-Schichtstapel 11. Erfindungsgemäß kann es von Vorteil sein, wenn der Precursor-Schichtstapel 11 mehrmals nacheinander abgeschieden wird. Diese Maßnahme kann insbesondere für die Kristallbildung und/oder Einstellung eines gewünschten Tiefenprofils von Schwefel (bezogen auf die Gesamtchalkogenmenge) des pentanären Verbindungshalbleiters Cu(In,Ga)(S,Se)₂ vorteilhaft sein. Gemäß einer Ausgestaltung des erfindungsgemäßen Verfahrens kann es bevorzugt sein, wenn die drei Precursor-Schichten 5.1, 6, 5.2 eine solche Zusammensetzung haben, dass das Verhältnis Chalkogen(e)/Metalle größer oder gleich 1 ist.

Wie in Figur 1 durch den Pfeil 8 schematisch angedeutet, werden die drei Precursor-Schichten 5.1, 6, 5.2 einer Wärmebehandlung in Form einer schnellen thermischen Prozessierung (allgemein bekannt als "Rapid Thermal Processing" (RTP)) unterzogen, wodurch eine reaktive Umwandlung der Metalle Cu, In, Ga und dem wenigstens einen Chalkogen S und/oder Se zum quaternären Verbindungshalbleiter Cu(In,Ga)Se₂ beziehungsweise Cu(In,Ga)S₂ oder pentanären Verbindungshalbleiter Cu(In,Ga)(S,Se)₂ bewirkt wird.

Die Wärmebehandlung der drei Precursor-Schichten 5.1, 6, 5.2 wird vorteilhafterweise zumindest zeitweilig in einer chalkogenhaltigen Atmosphäre innerhalb eines die Schichtstruktur 1 enthaltenden Prozessraums 13 durchgeführt, wobei abhängig von dem zu erzeugenden Verbindungshalbleiter ein oder mehrere Prozessgase (Schwefel und/oder Selen und/oder Schwefelwasserstoff (H₂S) und/oder Selenwasserstoff (H₂Se) beziehungsweise Kombinationen hiervon) in kontrollierter Weise dem Prozessraum 13 zugeführt werden. Jedes Prozessgas wird während zumindest eines (vorbestimmten) Zeitintervalls bei der Wärmebehandlung zugeführt, wobei das Zeitintervall kürzer als der Zeitraum der gesamten Wärmebehandlung ist oder dem Zeitraum der gesamten Wärmebehandlung entspricht. Die pro Zeiteinheit zugeführte Menge jedes Prozessgases kann während der Zugabe unverändert sein oder variieren. Insbesondere kann die Zusammensetzung der chalkogenhaltigen Atmosphäre bei der Wärmebehandlung unverändert sein oder variieren.

Die Wärmebehandlung erfordert:
- schnelle Aufheizraten im Bereich einiger K/s,
- Maximaltemperaturen oberhalb 400°C, bevorzugt oberhalb 500°C,
- hohe Temperaturhomogenität über die Substratfläche (lateral) und Schichtdicke.
- Sicherstellung eines ausreichend hohen, kontrollier- und reproduzierbaren Partialdrucks des zumindest einen Chalkogens (Se und/oder S) während der thermischen Prozessierung (Vermeidung von Se- und/oder S-Verlusten),
- optional eine kontrollierte Prozessgaszufuhr, von beispielsweise. H₂, N₂, Ar, S-Gas, Se-Gas, H₂S, H₂Se und Kombinationen hiervon, mit geeigneten Gas-Temperatur-Zeitprofilen.

Die Wärmebehandlung der drei Precursor-Schichten 5.1, 6, 5.2 kann beispielsweise unter Einsatz einer die Schichtstruktur 1 aufnehmenden Prozessbox, in einem Tunnel oder innerhalb einer die Schichtstruktur 1 umgebenden Prozesshaube erfolgen. Zum Durchführen der Wärmebehandlung können ein oder mehrere Schichtstrukturen 1 mit parallelen Substraten 3 neben- oder übereinander angeordnet werden (Dual-Substrate beziehungsweise Multilevel-Prozess), wie aus EP 2360720 A1, EP 2360721 A1, EP 2368860 A1 und WO 2012/025607 A1 bekannt ist.

Für eine Herstellung des pentanären Verbindungshalbleiters Cu(In,Ga)(S,Se)₂ wird die Wärmebehandlung der drei Precursor-Schichten 5.1, 6, 5.2 vorzugsweise unter Anwendung eines kontrollierten Temperatur-Prozessgas-Profils durchgeführt, so dass das Verhältnis S/(Se+S), das heißt der auf die summarischen Gehalte von S und Se bezogene Schwefelgehalt, im Absorber 2 ein definiertes Tiefenprofil aufweist.

Als "(Schwefel-)Tiefenprofil" wird der Schwefelgehalt beziehungsweise Verlauf des Werts des Quotienten S/(Se+S) im Absorber 2 entlang einer Linearabmessung des Absorbers 2, ausgehend von einer vom Substrat 3 abgewandten Oberfläche 9 des Absorber 2 hin zu einer dem Substrat 3 zugewandten Grenzfläche 10 in einer Richtung senkrecht zur Stapelfolge des Schichtaufbaus 7 beziehungsweise in Richtung der Schichtdicke bezeichnet.

Gemäß einer ersten Variante wird die Wärmebehandlung (RTP-Prozessierung) so durchgeführt, dass das Schwefel-Tiefenprofil über die Schichtdicke hinweg einen abnehmenden Verlauf hat, das heißt der Wert des Verhältnisses S/(Se+S) ist an der Oberfläche 9 maximal und nimmt von der Oberfläche 9 hin zur Grenzfläche 10 ab, so dass der Wert des Verhältnisses S/(Se+S) an der Grenzfläche 10 minimal ist.

Gemäß einer zweiten Variante wird die Wärmebehandlung (RTP-Prozessierung) so durchgeführt, dass das Schwefel-Tiefenprofil über die Schichtdicke hinweg einen zunehmenden Verlauf hat, das heißt der Wert des Verhältnisses S/(Se+S) ist an der Oberfläche 9 minimal und nimmt von der Oberfläche 9 hin zur Grenzfläche 10 zu, so dass der Wert des Verhältnisses S/(Se+S) an der Grenzfläche 10 maximal ist.

Gemäß einer dritten Variante wird die Wärmebehandlung (RTP-Prozessierung) so durchgeführt, dass das Schwefel-Tiefenprofil über die Schichtdicke hinweg zunächst einen abnehmenden Verlauf und anschließend einen zunehmenden Verlauf hat. Das heißt der Wert des Verhältnisses S/(Se+S) hat an der Oberfläche 9 einen ersten Maximalwert, nimmt von der Oberfläche 9 hin zur Grenzfläche 10 zunächst ab und nimmt zwischen Ober- und Grenzfläche 9, 10 einen (einzigen) Minimalwert an, und nimmt anschließend wieder zu, so dass der Wert des Verhältnisses S/(Se+S) an der Grenzfläche 10 einen zweiten Maximalwert annimmt, wobei der zweite Maximalwert zum ersten Maximalwert gleich sein kann, in der Regel aber verschieden ist.

Gemäß einer vierten Variante wird die Wärmebehandlung (RTP-Prozessierung) so durchgeführt, dass das Schwefel-Tiefenprofil über die Schichtdicke hinweg zunächst einen zunehmenden Verlauf und anschließend einen abnehmenden Verlauf hat, das heißt der Wert des Verhältnisses S/(Se+S) hat an der Oberfläche 9 einen ersten Minimalwert, nimmt von der Oberfläche 9 hin zur Grenzfläche 10 zunächst zu und nimmt zwischen Ober- und Grenzfläche 9, 10 einen (einzigen) Maximalwert an, und nimmt anschließend wieder ab, so dass der Wert des Verhältnisses S/(Se+S) an der Grenzfläche 10 einen zweiten Minimalwert annimmt, wobei der zweite Minimalwert zum ersten Minimalwert gleich sein kann, in der Regel aber verschieden ist.

In dem erfindungsgemäßen Verfahren ist optional eine Ätzung, beispielsweise mit KCN, möglich, um insbesondere bei kupferreicher Prozessierung (Cu/(In+Ga) > 1) Kupferselenide und/oder Kupfersulfide zu entfernen.

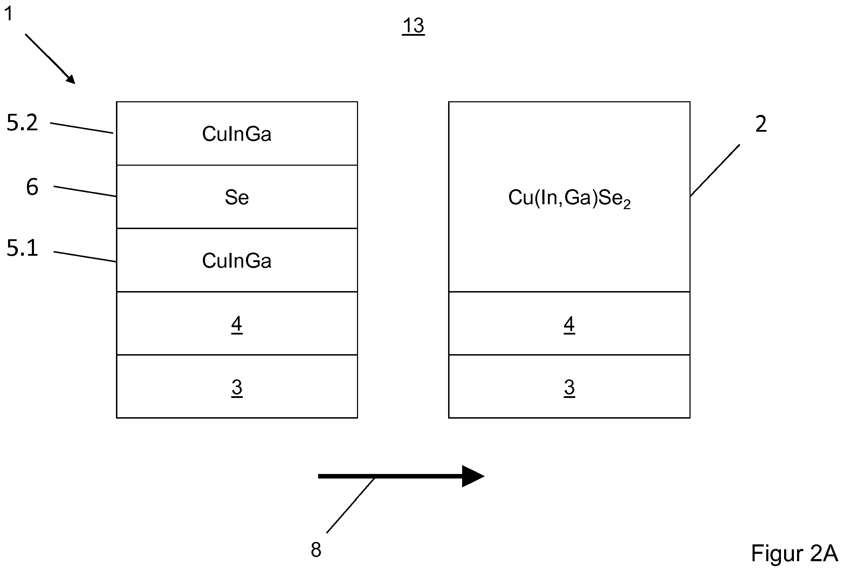

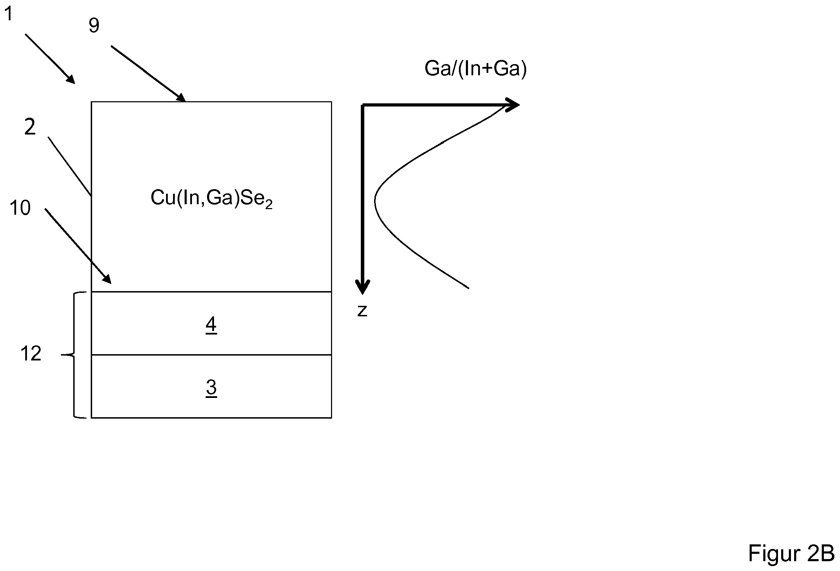

Im Folgenden werden unter Bezugnahme auf Figur 2 bis Figur 5 verschiedene Vorgehensweisen zur Herstellung eines aus einem pentanären Verbindungshalbleiter Cu(In,Ga)(S,Se)₂ oder aus einem quaternären Verbindungshalbleiter Cu(In,Ga)Se₂ beziehungsweise Cu(In,Ga)S₂ bestehenden Absorbers 2 in der Schichtstruktur 1 von Figur 1 angegeben.

### Ausführungsbeispiel 1

In Figur 2A ist eine erste Vorgehensweise zur Herstellung des aus dem quaternären Verbindungshalbleiter Cu(In,Ga)Se₂ bestehenden Absorbers 2 veranschaulicht.

Zunächst wird die erste Precursor-Schicht 5.1 auf der Rückelektrodenschicht 4 abgeschieden, beispielsweise durch Sputtern der Elemente Cu, In, Ga von drei Elementtargets. Anschließend wird die aus dem Chalkogen Selen bestehende zweite Precursor-Schicht 6 auf der ersten Precursor-Schicht 5.1 abgeschieden, was beispielsweise durch thermische Verdampfung (PVD) erfolgen kann. Anschließend wird die dritte Precursor-Schicht 5.2 durch Sputtern der Elemente Cu, In, Ga auf der zweiten Precursor-Schicht 6 abgeschieden. Das Abscheiden der dritten Precursor-Schicht 5.2 entspricht beispielsweise dem Abscheiden der ersten Precursor-Schicht 5.1. In diesem Ausführungsbeispiel sind die erste Precursor-Schicht 5.1 und die dritte Precursor-Schicht 5.2 in Aufbau und Cu-, In- und Ga-Gehalt identisch, so dass die erste Precursor-Schicht 5.1 und die dritte Precursor-Schicht 5.3 gleiche Mengen an Cu, In und Ga aufweisen.

Der Schichtenaufbau 7 umfasst demnach die Precursor-Elemente beziehungsweise Precursor-Phasen Cu-In-Ga/Se/Cu-In-Ga, im Weiteren als " Cu-In-Ga/Se/Cu-In-Ga-Precursor" bezeichnet.

Anschließend wird der Cu-In-Ga/Se/Cu-In-Ga-Precursor einer schnellen thermischen Prozessierung (RTP-Prozessierung) unterzogen. Die Prozessierung kann unter Zuführung von Se-Gas und/oder H₂Se-Gas zu dem die Schichtstruktur 1 enthaltenden Prozessraum 13 erfolgen. Die Temperatur bei der Wärmebehandlung ist vorzugsweise höher als 400°C, insbesondere bevorzugt höher als 500°C. Durch die Wärmebehandlung wird eine reaktive Umwandlung des Cu-In-Ga/Se/Cu-In-Ga-Precursors zum quaternären Verbindungshalbleiter Cu(In,Ga)Se₂ bewirkt, welcher den Absorber 2 ausbildet.

In Figur 2B ist links die Schichtstruktur 1 mit Absorber 2 und rechts das Gallium-Tiefenprofil im Absorber 2 bezogen auf den summarischen Gehalt an Gallium und Indium entlang der Richtung z senkrecht zur Stapelfolge des Schichtaufbaus 7 dargestellt. Das Gallium-Tiefenprofil ist von der Oberfläche 9 des Absorbers 2 hin zur Grenzfläche 10 zum Körper 12 so ausgebildet werden, dass der Galliumgehalt an der Absorberoberfläche 9 einen ersten Maximalwert hat, zur Körpergrenzfläche 10 hin bis zu einem Minimalwert abnimmt und anschließend wieder zunimmt, und an der Körpergrenzfläche 10 einen zweiten Maximalwert hat.

Dies lässt sich in einem einfachen Modell dadurch erklären, dass die Selenisierungsfront jeweils von der zweiten Selenhaltigen Precursor-Schicht 6 in die erste Precursor-Schicht 5.1 und damit in Richtung Körpergrenzfläche 10 sowie in die dritte Precursor-Schicht 5.2 und damit in Richtung der Oberfläche 9 des Absorbers 2 wandert. Dies führt zu einer Gallium-Anreicherung an der Körpergrenzfläche 10 zur Rückelektrode 4 und damit zu einem Back-Surface-Field in der Solarzelle. Back-Surface-Field bezeichnet hier das Ansteigen des Leitungsbandes in Richtung Grenzfläche 10 (Rückkontakt), hervorgerufen durch die erhöhte Ga-Menge im Verbindungshalbleiter. Außerdem führt die Gallium-Anreicherung an der Oberfläche 9 des Absorbers 2 zum späteren Frontkontakt zu einer Aufweitung der Bandlücke in diesem Bereich. Beides führt zu einer vorteilhaften Erhöhung der Leerlaufspannung und zu einer Erniedrigung des Temperaturkoeffizienten der Dünnschichtsolarzelle.

### Ausführungsbeispiel 2

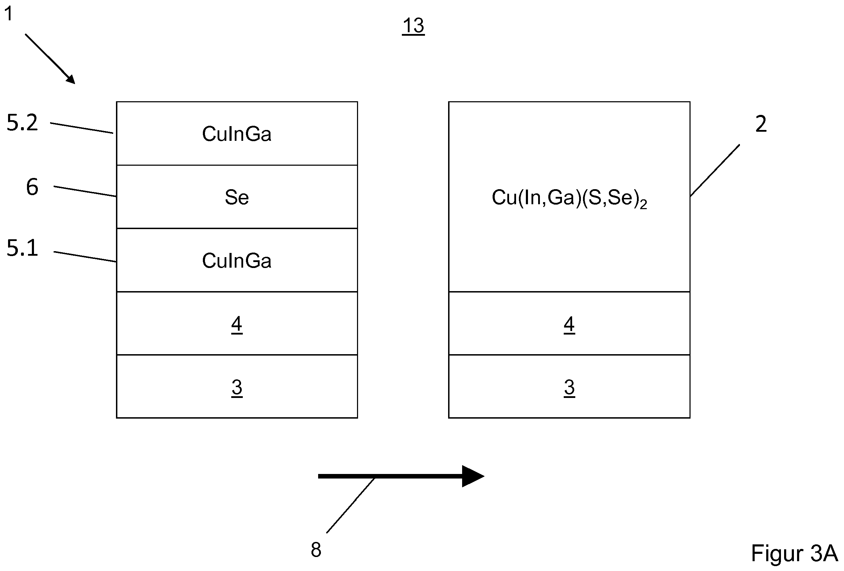

In Figur 3A ist eine Methode zur Herstellung eines aus einem pentanären Verbindungshalbleiter Cu(In,Ga)(S,Se)₂ bestehenden Absorbers 2 veranschaulicht. Um unnötige Wiederholungen zu vermeiden, werden lediglich die Unterschiede zu Ausführungsbeispiel 1 erläutert und ansonsten wird auf die dort gemachten Ausführungen Bezug genommen. Der Aufbau der Schichtstruktur 1 und des Cu-In-Ga/Se/Cu-In-Ga-Precursors entspricht demjenigen aus Ausführungsbeispiel 1.

Anschließend wird der Cu-In-Ga/Se/Cu-In-Ga-Precursor einer schnellen thermischen Prozessierung (RTP-Prozessierung) in einer schwefelhaltigen Atmosphäre unterzogen. Zu diesem Zweck wird S-Gas und/oder H₂S-Gas dem die Schichtstruktur 1 enthaltenden Prozessraum 13 zugeführt. Die Temperatur bei der Wärmebehandlung ist vorzugsweise höher als 400°C, insbesondere bevorzugt höher als 500°C. Durch die Wärmebehandlung wird eine reaktive Umwandlung des Cu-In-Ga/Se/Cu-In-Ga-Precursors zum pentanären Verbindungshalbleiter Cu(In,Ga)(S,Se)₂ bewirkt, welcher den Absorber 2 ausbildet.

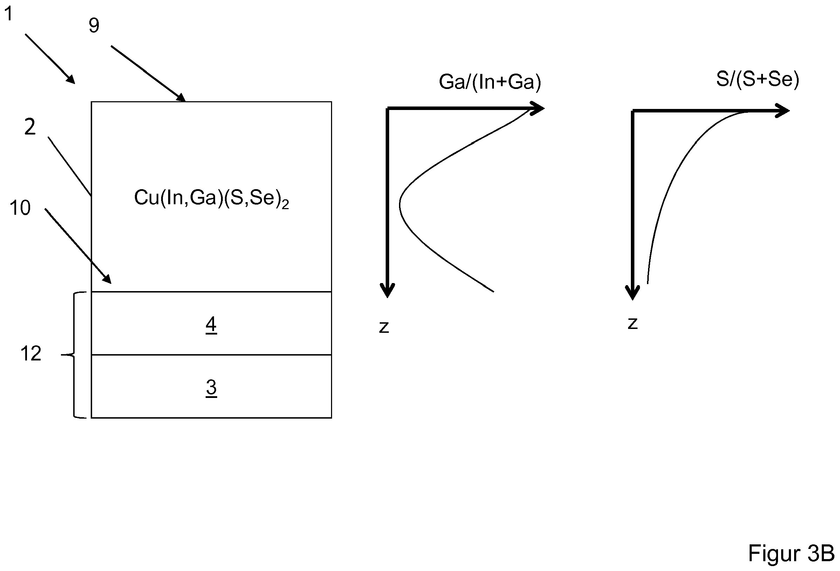

In Figur 3B ist links die Schichtstruktur 1 mit fertigem Absorber 2 und in der Mitte das Gallium-Tiefenprofil im Absorber 2 bezogen auf den summarischen Gehalt an Gallium und Indium entlang der Richtung z dargestellt. Das Gallium-Tiefenprofil ist von der Oberfläche 9 des Absorbers 2 hin zur Grenzfläche 10 zum Körper 12 so ausgebildet werden, dass der Galliumgehalt an der Absorberoberfläche 9 einen ersten Maximalwert hat, zur Körpergrenzfläche 10 hin bis zu einem Minimalwert abnimmt und anschließend wieder zunimmt, und an der Körpergrenzfläche 10 einen zweiten Maximalwert hat. Durch das erzeugte Bandlückenprofil des Absorbers 4 kann eine Verbesserung des Wirkungsgrads der Dünnschichtsolarzelle erreicht werden.

Die Prozessierung des selenhaltigen Cu-In-Ga/Se/Cu-In-Ga-Precursors in schwefelhaltiger Atmosphäre ermöglicht einen Austauschprozess von Selen und Schwefel zwischen der zweiten Precursor-Schicht 6 und der Prozessatmosphäre. Dadurch kann der Schwefelgehalt und somit die Bandlücke des gebildeten Cu(In,Ga)(S,Se)₂-Verbindungshalbleiters während des Schichtbildungsprozesses, zusätzlich zum Gallium-Tiefenprofils, gezielt beeinflusst werden. Insofern kann durch eine zeit- und/oder konzentrationsabhängige Variation des Schwefelgehalts in der Reaktionsgasatmosphäre beim thermischen Prozessieren in gewünschter Weise ein definiertes Schwefel-Konzentrationsprofil (Tiefenprofil) entlang der Schichtdicke z des gebildeten Cu(In,Ga)(S,Se)₂-Verbindungshalbleiters erzeugt werden. Durch das erzeugte Bandlückenprofil des Absorbers 4 kann eine weitere Verbesserung des Wirkungsgrads der Dünnschichtsolarzelle erreicht werden.

Beispielsweise kann in einer speziellen Ausgestaltung des Verfahrens in einer ersten (früheren) Phase ein inertes Prozessgas (z.B. Stickstoff (N₂) oder Argon (Ar)) und in einer zweiten (späteren) Prozessphase als Prozessgas S-Gas und/oder H₂S-Gas (oder ein anderes S-haltiges Gas) zugeführt werden. Beispielsweise, jedoch nicht zwingend, könnte S-Gas und/oder H₂S-Gas nur in einer zweiten Hälfte des Zeitintervalls der Wärmebehandlung zugeführt werden, wobei das Zeitintervall der Zuleitung bis zum Ende der Wärmebehandlung dauern oder schon früher enden kann. Durch Zuführung von H₂S-Gas und/oder S-Gas wird durch Einbau von S und darauf folgende Diffusionsprozesse ein Schwefelprofil so erzeugt, dass das Verhältnis S/(Se+S) an der Oberfläche 9 maximal ist und zur Grenzfläche 10 hin abnimmt.

In Figur 3B ist rechts das resultierende Schwefel-Tiefenprofil im Absorber 2 bezogen auf den summarischen Gehalt an Schwefel und Selen entlang der Richtung z dargestellt.

Alternativ wäre es möglich, dass S-Gas und/oder H₂S-Gas während einer (früheren) ersten Phase, (beispielsweise, jedoch nicht zwingend, während der ersten Hälfte des Zeitintervalls) der Wärmebehandlung und gegebenenfalls in einer zweiten (späteren) Prozessphase ein Inertgas zugeführt wird, um das Schwefel-Tiefenprofil in gezielter Weise zu beeinflussen. Beispielsweise könnten zwei Zeitintervalle in denen S-Gas und/oder H₂S-Gas zugeführt wird durch ein Zeitintervall in dem nur Inertgas zugeführt wird, unterbrochen sein. Denkbar wäre aber auch, dass S-Gas und/oder H₂S-Gas während der kompletten Wärmebehandlung zugeführt wird.

### Ausführungsbeispiel 2A

In einer Variante des Ausführungsbeispiels 2 wird in einer (früheren) ersten Phase das S-Gas und/oder H₂S-Gas, in einer zweiten (späteren) Phase der Wärmebehandlung das Inertgas und in einer dritten (noch späteren) Phase wieder das S-Gas und/oder H₂S-Gas zugeführt, um das Schwefel-Tiefenprofil in gezielter Weise zu beeinflussen.

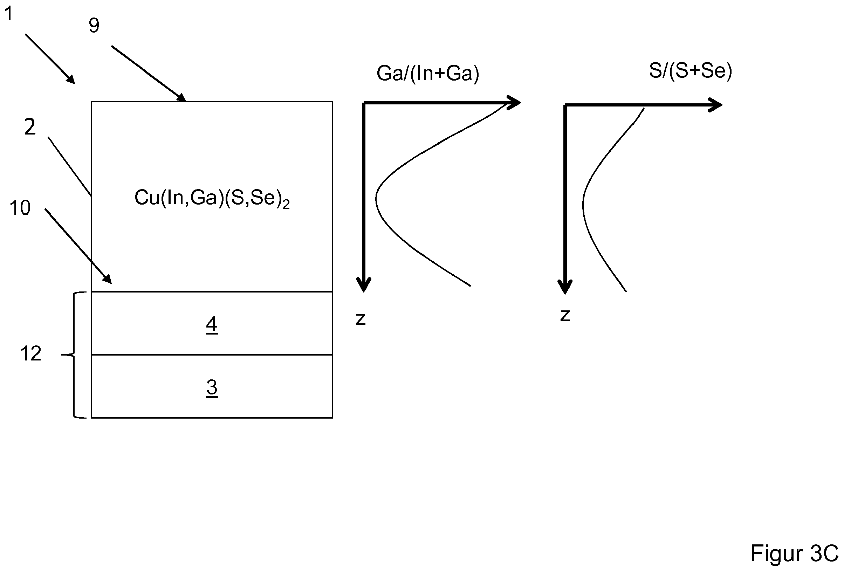

In Figur 3C ist rechts das resultierende Schwefel-Tiefenprofil im Absorber 2 bezogen auf den summarischen Gehalt an Schwefel und Selen entlang der Richtung z dargestellt. Das Schwefel-Tiefenprofil zeigt ein Maximum an der Oberseite 9 und der Grenzfläche 10 des Absorbers 2.

Die durch die Gallium-Anreicherung an der Oberfläche 9 und der Grenzfläche 10 erhöhte Bandlücke führt in der Dünnschichtsolarzelle (20) zu einer Erhöhung der Leerlaufspannung und des Wirkungsgrades. Andererseits wird die Höhe des Kurzschlussstroms durch das Minimum der Bandlücke im Innern des Absorbers 2 bestimmt. In Kombination führt die Doppelmaximastruktur des Galliumgehalts und des Schwefelgehaltes in vorteilhafter Weise zu einer Erhöhung des Wirkungsgrades der Dünnschichtsolarzelle.

### Ausführungsbeispiel 3

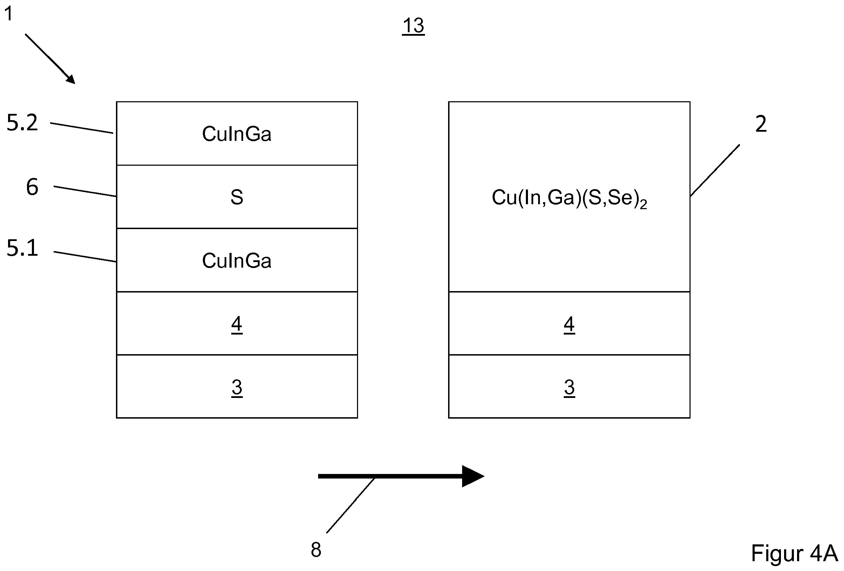

In Figur 4A ist eine weitere Methode zur Herstellung des aus dem pentanären Verbindungshalbleiter Cu(In,Ga)(S,Se)₂ bestehenden Absorbers 2 veranschaulicht. Um unnötige Wiederholungen zu vermeiden, werden lediglich die Unterschiede zu Ausführungsbeispiel 2 erläutert und ansonsten wird auf die dort gemachten Ausführungen Bezug genommen.

Demnach ist anstatt einer Abscheidung von Se zur Herstellung der zweiten Precursor-Schicht 6 eine Abscheidung des Chalkogens S vorgesehen, so dass der Schichtenaufbau 7 die Precursor-Elemente Cu-In-Ga/S/Cu-In-Ga (Cu-In-Ga/S/Cu-In-Ga-Precursor) umfasst. Der Cu-In-Ga/S/Cu-In-Ga-Precursor wird einer schnellen thermischen Prozessierung in einer Sehaltigen Atmosphäre unterzogen. Zu diesem Zweck wird Se-Gas und/oder H₂Se-Gas dem die Schichtstruktur 1 enthaltenden Prozessraum 13 zugeführt. Durch die Wärmebehandlung wird eine reaktive Umwandlung des Cu-In-Ga/S/Cu-In-Ga-Precursors zum pentanären Verbindungshalbleiter Cu(In,Ga)(S,Se)₂ bewirkt, welcher den Absorber 2 ausbildet.

Die Prozessierung des S-haltigen Cu-In-Ga/S/Cu-In-Ga-Precursors in Se-haltiger Atmosphäre ermöglicht einen Austauschprozess von S und Se zwischen der zweiten Precursor-Schicht 6 und der Gasphase. Dadurch kann der Schwefelgehalt des gebildeten Cu(In,Ga)(S,Se)₂-Verbindungshalbleiters während des Schichtbildungsprozesses gezielt beeinflusst werden.

Beispielsweise kann in einer speziellen Ausgestaltung des Verfahrens in einer (späteren) zweiten Phase als Prozessgas Se-Gas und/oder H₂Se-Gas (oder ein anderes Se-haltiges Gas) und in einer (früheren) ersten Prozessphase ein Inertgas (z.B. Stickstoff (N₂) oder Argon (Ar)) zugeführt werden. Beispielsweise, jedoch nicht zwingend, könnte Se-Gas und/oder H₂Se-Gas nur in einer zweiten Hälfte des Zeitintervalls der Wärmebehandlung zugeführt werden. Durch Zuführung von H₂Se-Gas und/oder Se-Gas wird durch Einbau von Se und darauf folgende Diffusionsprozesse ein Schwefelprofil so erzeugt, dass das Verhältnis S/(Se+S) an der Oberfläche 9 minimal ist und zur Grenzfläche 10 hin zunimmt.

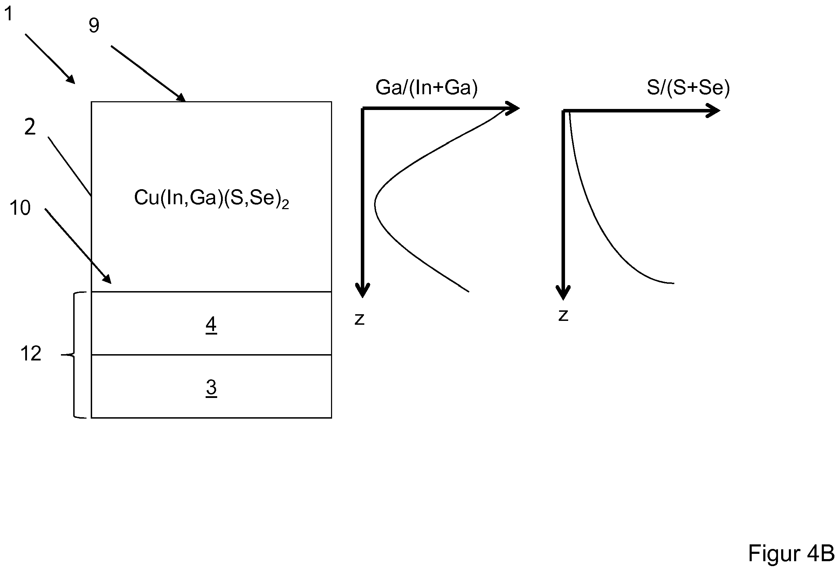

In Figur 4B ist links die Schichtstruktur 1 mit fertigem Absorber 2, in der Mitte das resultierende Gallium-Tiefenprofil entlang der Richtung z entlang des Absorbers 2 und rechts das resultierende Schwefel-Tiefenprofil dargestellt.

### Ausführungsbeispiel 4

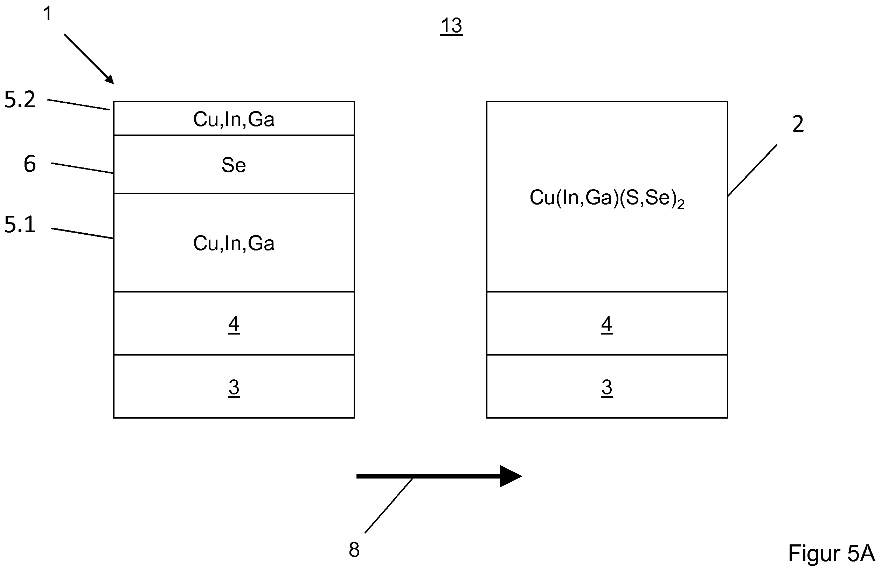

In Figur 5A ist eine weitere Methode zur Herstellung des aus dem pentanären Verbindungshalbleiter Cu(In,Ga)(S,Se)₂ bestehenden Absorbers 2 veranschaulicht. Um unnötige Wiederholungen zu vermeiden, werden lediglich die Unterschiede zu Ausführungsbeispiel 2 erläutert und ansonsten wird auf die dort gemachten Ausführungen Bezug genommen.

Im Unterschied zu Ausführungsbeispiel 2 wird nicht von einem Cu-In-Ga/Se/Cu-In-Ga-Precursor ausgegangen, bei dem die erste Precursor-Schicht 5.1 und die dritte Precursor-Schicht 5.2 den gleichen Aufbau und die gleichen Mengen an Cu, In und Ga enthalten.

In Figur 5A ist eine Schichtstruktur 1 dargestellt, bei der etwa 80 % der Gesamtmenge von Cu, In, Ga in der ersten Precursor-Schicht 5.1 angeordnet sind und etwa 20 % in der dritten Precursor-Schicht 5.2. Die Mengenverhältnisse von Cu, In, Ga werden dabei über die jeweiligen Schichtdicken eingestellt. Die Wärmebehandlung erfolgt beispielsweise in einer Schwefel-haltigen Prozessatmosphäre, wie unter Ausführungsbeispiel 2 dargestellt ist.

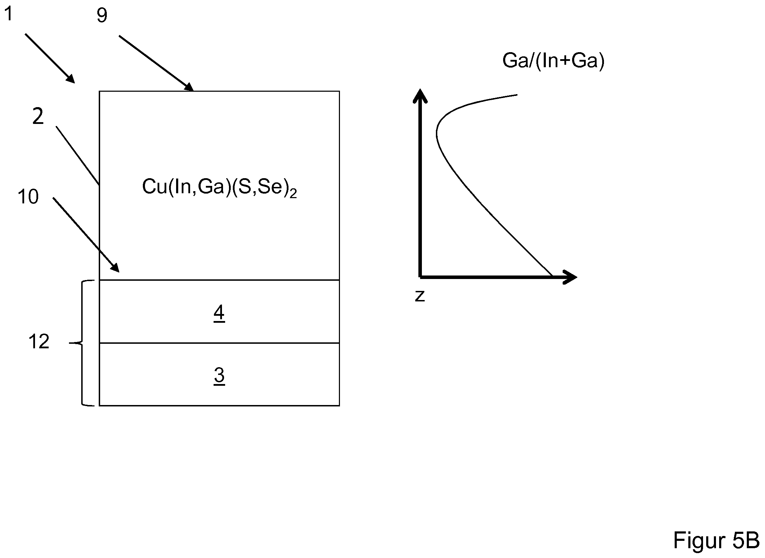

In Figur 5B ist das Gallium-Tiefenprofil des resultierenden Absorbers 2 dargestellt. Das Gallium-Tiefenprofil zeigt ein Maximum bezogen auf den summarischen Gehalt von Gallium und Indium an der Grenzfläche 10 zum Körper 12 und an der Oberfläche 9 des Absorbers 2. Das Minimum des Galliumgehalts ist zur Oberfläche 9 des Absorbers 2 hin verschoben und liegt bei etwa 20 % der Absorberdicke.

### Ausführungsbeispiel 5

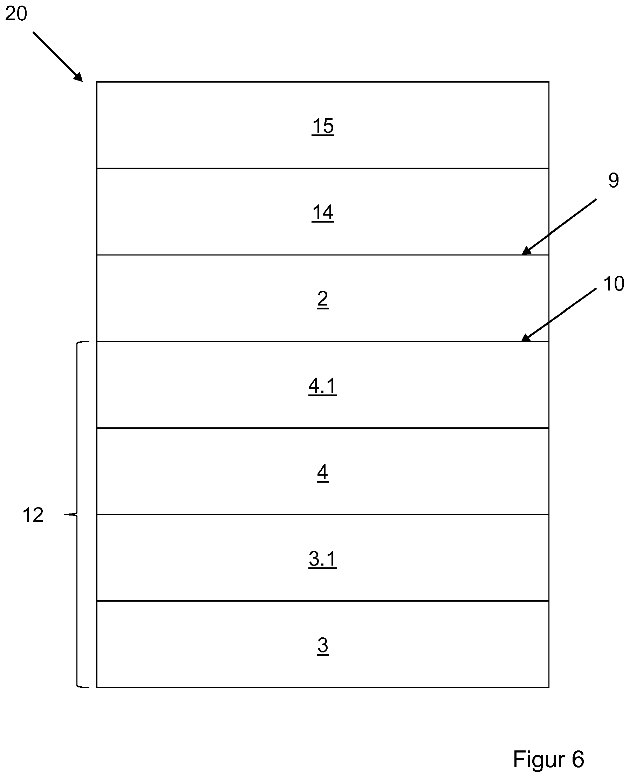

Figur 6 zeigt ein Ausgestaltungsbeispiel einer erfindungsgemäßen Dünnschichtsolarzelle 20. Die Dünnschichtsolarzelle 20 weist ein Substrat 3 auf, das beispielsweise aus einer 2,1 mm dicken Kalk-Natron-Glasscheibe besteht. Auf dem Substrat 1 ist eine Diffusionssperrschicht 3.1 angeordnet, die die Diffusion von Natrium aus dem Substrat 3 in die Halbleiterschichten der Dünnschichtsolarzelle 20 verhindert. Die Diffusionssperrschicht 3.1 besteht beispielsweise aus einer 100 nm dicken Siliziumnitrid-Schicht.

Auf der Diffusionssperrschicht 3.1 ist eine Rückelektrodenschicht 4 angeordnet. Die Rückelektrodenschicht 4 enthält beispielsweise eine 450 nm dicke Molybdän-Schicht. In einer vorteilhaften Weiterbildung der erfindungsgemäßen Dünnschichtsolarzelle 20 kann die Rückelektrodenschicht 4 ein Mehrschichtsystem sein, wobei beispielsweise zwischen zwei Einzelschichten aus Molybdän eine Titannitrid-Schicht angeordnet ist.

Auf der Rückelektrodenschicht 4 ist eine Rückelektrodenübergangsschicht 4.1 angeordnet, die Molybdän und - je nach Absorber 2 - Schwefel und/oder Selen enthält. Die Rückelektrodenübergangsschicht 4.1 hat beispielsweise ein Dicke von 50 nm bis 500 nm.

Auf der Rückelektrodenübergangsschicht 4.1 ist ein erfindungsgemäßer Absorber 2 angeordnet. Der Absorber 2 besteht aus einem quaternären Verbindungshalbleiter Cu(In,Ga)Se₂, einem quaternären Verbindungshalbleiter Cu(In,Ga)S₂ oder einem pentanären Verbindungshalbleiters Cu(In,Ga)(S,Se)₂. Die Schichtdicke des Absorbers 2 beträgt beispielsweise von 1 µm bis 2 µm. Der Absorber 2 hat eine Bandlücke von minimal 1.0 eV. Der Absorber 2 weist eine Grenzfläche 10 zum Körper 12 auf, der aus Substrat 3, Diffusionssperrschicht 3.1, Rückelektrodenschicht 4 und Rückelektrodenübergangsschicht 4.1 besteht.

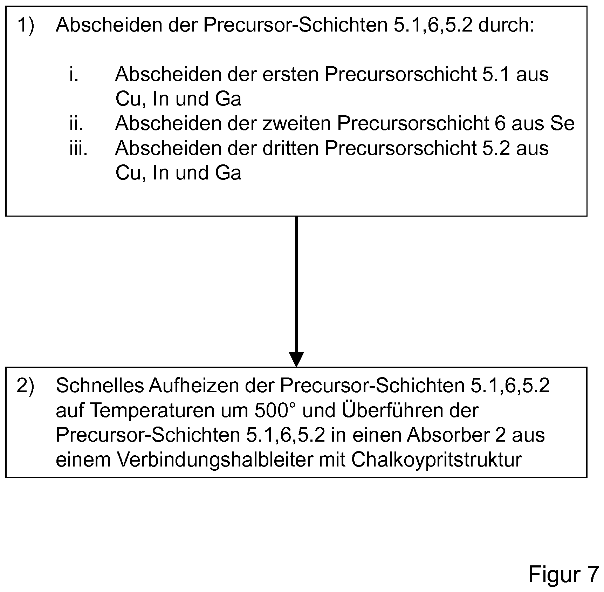

Figur 7 zeigt ein Ausführungsbeispiel der erfindungsgemäßen Verfahrensschritte zur Herstellung des Absorbers 2 anhand eines Flussdiagramms. Die Herstellung des Absorbers erfolgt beispielsweise durch die folgenden Prozessschritte:
In einem ersten Schritt wird die erste Precursor-Schicht 5.1 aus Cu, In und Ga auf der Rückelektrodenübergangsschicht 4.1 abgeschieden. Dazu wird beispielsweise Kupfer und Gallium von einem von einem Target mit einem atomaren Anteil von 85% Cu und 25% Ga und Indium von einem Indium-Target durch Sputtern abgeschieden. Das Kupfer-Gallium-Target und das Indium-Target haben beispielsweise eine hohe Reinheit von mehr als 99,99% (≥ 4N).

Die erste Precursor-Schicht 5.1 hat beispielsweise eine Schichtdicke von etwa 400 nm, was einer Gesamtmassenbelegung von Cu, In und Ga von etwa 0,2 mg/cm² bis 0,25 mg/cm² entspricht. Diese wird beispielsweise durch drei Doppellagen Cu/Ga und In aufgebracht.

Anschließend wir die gewünschte Selen-Menge in der zweiten Precursor-Schicht 6 auf der ersten Precursor-Schicht 5.1 abgeschieden, beispielsweise durch thermisches Verdampfen. Die Schichtdicke der zweiten Precursor-Schicht 6 beträgt beispielsweise 1000 nm bis 1500 nm Selen.

Anschließend wird die dritte Precursor-Schicht 5.2 auf der zweiten Precursor-Schicht 6 abgeschieden. Die dritte Precursor-Schicht 5.2 enthält beispielsweise eine Doppellage Cu/Ga und In oder eine Doppellage In und Cu/Ga.

Während der Abscheidung der Precursor-Schichten 5.1, 6, 5.2 kann eine Dotierstoffzugabe von beispielsweise Natrium erfolgen.

In einem zweiten Schritt werden die Precursor-Schichten 5.1, 6, 5.2 durch schnelles Aufheizen auf Temperaturen um 500°C in einen Verbindungshalbleiter mit Chalkopyritstruktur überführt. Die Wärmebehandlung kann beispielsweise in chalkogenhaltiger Atmosphäre und insbesondere in einer Schwefel-haltigen Atmosphäre (beispielsweise durch H₂S-Zugabe oder S-Gas) erfolgen. Der entstandene Verbindungshalbleiter bildet den Absorber 2 der Dünnschichtsolarzelle 20.

Der erfindungsgemäße Absorber 2 weist dabei ein definiertes Gallium-Tiefenprofil auf, das so ausgebildet ist, dass der Galliumgehalt an der Oberfläche 9 einen ersten Maximalwert hat, zur Grenzfläche 10 hin bis zu einem Minimalwert abnimmt und anschließend wieder zunimmt, und an der Grenzfläche 10 einen zweiten Maximalwert hat.

Auf der Oberfläche 9 des Absorbers 2 ist eine Pufferschicht 14 angeordnet. Die Pufferschicht 14 enthält beispielsweise eine Indiumsulfid-Schicht und eine intrinsisch dotierte Zinkoxid-Schicht. Auf der Pufferschicht 14 ist eine Frontelektrodenschicht 15, beispielsweise aus Aluminium-dotiertem Zinkoxid angeordnet. Die Dicke der Frontelektrodenschicht 15 beträgt beispielsweise 1200 nm.

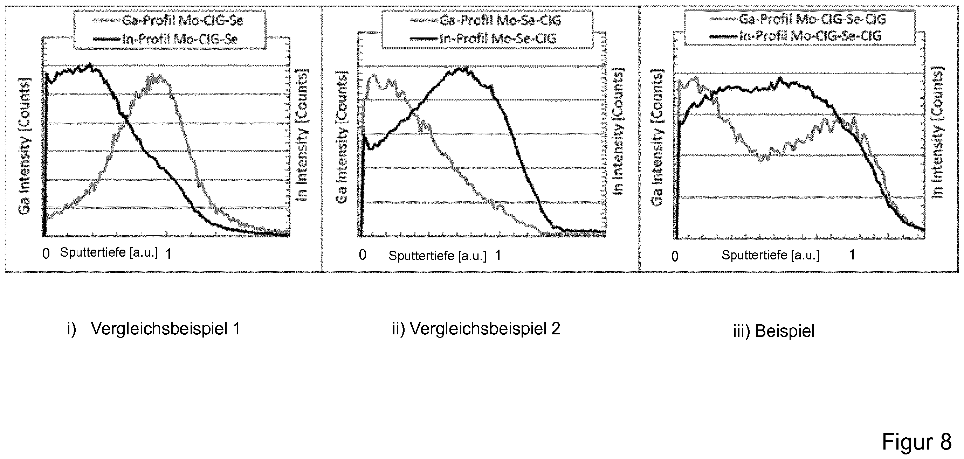

Figur 8 zeigt Gallium- und Indium-Tiefenprofile gemessen durch hochaufgelöste Time-of-Flight Secondary Ion Mass Spectrometry (ToF-SIMS) von drei verschieden präparierten Absorbern 2. Figur 8 i) und Figur 8 ii) zeigen Vergleichsbeispiele und Figur 8 iii) ein erfindungsgemäßes Beispiel.

Die untersuchten Absorber 2 wurden auf einer Rückelektrodenschicht 4 abgeschieden. Die metallischen Precursor-Schichten wurden Schichtweise von einem Kupfer-Gallium-Target und einem Indium-Target aufgesputtert. Die Chalkogen-haltige Precursor-Schicht wurde durch thermisches Verdampfen von Selen hergestellt. Die Precursor-Schichten wurden nicht mit Natrium dotiert. Die Wärmebehandlung zur Ausbildung des Verbindungshalbleiters erfolgte ohne Zusatz von Schwefel im Prozessraum.

In Tabelle 1 ist eine Übersicht über die Precursoren dargestellt, die abgeschieden, prozessiert und anschließend charakterisiert wurden.

**Tabelle 1**

| | 1. Precursor-Schicht | 2. Precursor-Schicht | 3. Precursor-Schicht |
|---|---|---|---|
| Vergleichsbeispiel 1 | Cu/In/Ga (100%) | Se | - |
| Vergleichsbeispiel 2 | Se | Cu/In/Ga (100%) | - |
| erfindungsgemäßes Beispiel | Cu/In/Ga (50%) | Se | Cu/In/Ga (50%) |

In Vergleichsbeispiel 1 wurde ein Cu/In/Ga-Se-Precursor, in Vergleichsbeispiel 2 ein Se-Cu/In/Ga-Precursor und im Beispiel ein erfindungsgemäßer Cu/In/Ga-Se-Cu/In/Ga-Precursor untersucht. Beim erfindungsgemäßen Cu/In/Ga-Se-Cu/In/Ga-Precursor ist die Schichtdicke einer einzelnen Cu/In/Ga-Precursor-Schicht etwa halb so groß wie bei den Cu/In/Ga-Schichten der Vergleichsbeispiele. Damit konnten gleiche Mengenverhältnisse der Metallkomponenten im Verbindungshalbleiter sichergestellt werden.

Die Ergebnisse einer TOF-SIMS-Analyse der so präparierten Absorberschichten sind in Figur 8 i)-iii) dargestellt: In Figur 8 i)-iii) ist auf der horizontalen Achse jeweils die Sputtertiefe normiert auf die Dicke der Absorbers 2 aufgetragen, wobei die Analyse auf der Oberfläche 9 des Absorbers 2 beginnt. Der Absorber 2 entspricht dem Bereich 0 bis 1 auf der horizontalen Achse und die Rückelektrodenschicht 4 dem Bereich mit Werten >1. Auf der vertikalen Achse ist die Intensität (Intensity) der Gallium- beziehungsweise Indium-Zählrate aufgetragen.

Figur 8 i) zeigt die Tiefenprofilanalyse mit TOF-SIMS für das Vergleichsbeispiel 1 nach dem Stand der Technik, wobei der Absorber 2 ausgehend von einem Cu/In/Ga-Se-Precursor hergestellt wurde. Die Tiefenprofilanalyse zeigt ein Minimum im Galliumgehalt an der Oberfläche 9 des Absorbers 2 (Sputtertiefe = 0). Mit zunehmender Sputtertiefe steigt der Galliumgehalt an und erreicht sein Maximum bei einer Sputtertiefe von 1, was der Grenzfläche 10 zur Rückelektrode 4 entspricht. Gleichzeitig zeigt der Indium-Gehalt an der Oberfläche 9 des Absorbers 2 (Sputtertiefe = 0) ein Maximum. Mit zunehmender Sputtertiefe nimmt der Indium-Gehalt ab und erreicht ein Minimum bei einer Sputtertiefe von 1, was etwa der Grenzfläche 10 zur Rückelektrode 4 entspricht.

Figur 8 ii) zeigt die Tiefenprofilanalyse mit TOF-SIMS für das Vergleichsbeispiel 2, wobei der Absorber 2 ausgehend von einem Se-Cu/In/Ga-Precursor hergestellt wurde. Die Tiefenprofilanalyse zeigt ein Maximum im Gallium-Gehalt an der Oberfläche 9 des Absorbers 2 (Sputtertiefe = 0). Mit zunehmender Sputtertiefe sinkt der Galliumgehalt und erreicht sein Minimum bei einer Sputtertiefe von 1, was der Grenzfläche 10 zur Rückelektrode 4 entspricht. Gleichzeitig zeigt der Indiumgehalt an der Oberfläche 9 des Absorbers 2 (Sputtertiefe = 0) ein Minimum. Mit zunehmender Sputtertiefe nimmt der Indiumgehalt zu und erreicht ein Maximum bei einer Sputtertiefe von 1, was etwa der Grenzfläche 10 zur Rückelektrode 4 entspricht.

Figur 8 iii) zeigt die Tiefenprofilanalyse mit TOF-SIMS für das erfindungsgemäße Beispiel, wobei der Absorber 2 ausgehend von einem Cu/In/Ga-Se-Cu/In/Ga-Precursor hergestellt wurde. Die Tiefenprofilanalyse zeigt ein Maximum im Galliumgehalt an der Oberfläche 9 des Absorbers 2 (Sputtertiefe = 0). Mit zunehmender Sputtertiefe nimmt der Galliumgehalt ab und erreicht ein Minium bei Sputtertiefen, die etwa der Hälfte der Dicke des Absorbers 2 entsprechen. Anschließend nimmt der Galliumgehalt wieder zu und erreicht ein zweites Maximum bei einer Sputtertiefe von etwa 1, was etwa der Grenzfläche 10 zur Rückelektrode 4 entspricht. Gleichzeitig zeigt der Indium-gehalt an der Oberfläche 9 des Absorbers 2 (Sputtertiefe = 0) ein Minimum. Mit zunehmender Sputtertiefe nimmt der Indium-Gehalt ab und erreicht bei Sputtertiefen, die etwa der Hälfte der Dicke des Absorbers 2 entsprechen, ein Maximum. Für größere Sputtertiefen nimmt der Indium-Gehalt wieder ab und erreicht ein Minimum bei einer Sputtertiefe von 1, was der Grenzfläche 10 zur Rückelektrode 4 entspricht.

Der erfindungsgemäße Schichtaufbau des Cu/In/Ga-Se-Cu/In/Ga-Precursor führt somit zum gewünschten Gallium-Doppelprofil mit einem Gallium-Maximum an der Oberfläche 9 und an der Grenzfläche 10 des Absorbers 2.

Die Ausbildung des erfindungsgemäßen Gallium-Doppelprofil lässt sich im Rahmen des folgenden Modells verstehen: Gallium ist gegenüber Selen deutlich reaktionsträger als beispielsweise Kupfer oder Indium. Bei einem Cu/In/Ga-Se-Cu/In/Ga-Precursor reagiert im Wärmebehandlungprozess das flüssige Selen mit den Cu-,In- und Ga-Komponenten zu binären Seleniden. Diese Reaktion beginnt im Cu/In/Ga-Se-Cu/In/Ga-Precursor von der zweiten Selen-haltigen Precursor-Schicht 6 und setzte sich nach unten in die erste Precursor-Schicht 5.1 und nach oben in die dritte Precursor-Schicht 5.2 fort. Aufgrund der bestehenden Unterschiede in der Selenisierungskinetik der Metalle Cu, In, Ga kommt es zu einer Anreicherung Ga-haltiger Metalllegierungen an den Selen-abgewandten Seiten. Es findet keine vollständige Interdiffusion von Gallium statt und es verbleibt ein Verbindungshalbleiter mit einem Indium-reichen mittleren Bereich und Maxima im Gallium-Gehalt an der Oberfläche 9 und der Grenzfläche 10.

Mit der vorliegenden Erfindung ist es somit erstmals möglich, ein Gallium-Doppelprofil mit einem Gallium-Maximum an Oberseite und der Unterseite eines Absorbers mithilfe eines Zweistufenprozesses aus Schichtabscheidung und Wärmebehandlung (RTP) einzustellen. Dies kann kombiniert werden mit einem Schwefel-Profil, eingestellt beispielsweise durch H₂S-Zufuhr während des Wärmebehandlungsprozess. Der durch das Gallium-Doppelprofil und zusätzlich durch das Schwefel-Profil optimierte Bandlückenverlauf im Absorber 2 führt zu einer hohen Leerlaufspannung in Kombination mit einer hohen Kurzschlussstromstärke. Beides führt zu einer Wirkungsgradsteigerung der Dünnschichtsolarzelle. Ebenso wird der Temperaturkoeffizient der Dünnschichtsolarzelle vorteilhaft verringert.

Dies war für den Fachmann unerwartet und überraschend.

### Bezugszeichenliste

1 Schichtstruktur
2 Verbindungshalbleiter, Absorber
3 Substrat
3.1 Diffusionssperrschicht
4 Rückelektrodenschicht
4.1 Rückelektrodenübergangsschicht
5.1 erste Precursor-Schicht
5.2 dritte Precursor-Schicht
6 zweite Precursor-Schicht
7 Schichtaufbau
8 Pfeil
9 Oberfläche
10 Grenzfläche
11 Precursor-Schichtstapel
12 Körper
13 Prozessraum
14 Pufferschicht
15 Frontelektrodenschicht
20 Dünnschichtsolarzelle
z Schichtdicke

## Patentansprüche

1. Verfahren zur Herstellung eines Verbindungshalbleiters (2), welches die folgenden Schritte umfasst:
- Erzeugen zumindest eines Precursor-Schichtstapels (11), bestehend aus einer ersten Precursor-Schicht (5.1), einer zweiten Precursor-Schicht (6) und einer dritten Precursor-Schicht (5.2), wobei in einer ersten Stufe die erste Precursor-Schicht (5.1) hergestellt wird durch Abscheiden der Metalle Kupfer, Indium und Gallium auf einen Körper (12), und in einer zweiten Stufe die zweite Precursor-Schicht (6) hergestellt wird durch Abscheiden zumindest eines Chalkogens, gewählt aus Schwefel und Selen, auf der ersten Precursor-Schicht (5.1), und in einer dritten Stufe die dritte Precursor-Schicht (5.2) hergestellt wird durch Abscheiden der Metall Kupfer, Indium und Gallium auf der zweiten Precursor-Schicht (6);
- Wärmebehandeln des zumindest einen Precursor-Schichtstapels (11) in einem Prozessraum (13) derart, dass die Metalle der ersten Precursor-Schicht (5.1), das zumindest eine Chalkogen der zweiten Precursor-Schicht (6) und die Metalle der dritten Precursor-Schicht (5.2) zum Verbindungshalbleiter (2) reaktiv umgesetzt werden.

2. Verfahren nach Anspruch 1, bei welchem mindestens ein Prozessgas zumindest zeitweilig während der Wärmebehandlung des zumindest einen Precursor-Schichtstapels (11) in den Prozessraum (13) zugeführt wird und im Prozessgas mindestens ein Chalkogen, gewählt aus Schwefel und Selen, und/oder mindestens eine chalkogenhaltige Verbindung, gewählt aus einer schwefelhaltigen Verbindung und einer selenhaltigen Verbindung, enthalten ist.

3. Verfahren nach Anspruch 1 oder 2, bei welchem
- die erste Precursor-Schicht (5.1) und/oder die dritte Precursor-Schicht (5.2) durch Sputtern von einer oder mehreren Einzellagen aus einem Kupfer-Gallium-Legierungstarget und einem Indium-Target oder aus einem Kupfer-Indium-Legierungstarget und einem Kupfer-Gallium-Legierungstarget oder aus einem Kupfer-Gallium-Indium-Legierungstarget abgeschieden werden, und/oder
- die zweite Precursor-Schicht (6) aus Einzellagen der Chalkogene Schwefel und/oder Selen abgeschieden wird.

4. Verfahren nach einem der Ansprüche 1 bis 3, bei welchem eine vierte Precursor-Schicht auf der dritten Precursor-Schicht (5.2) abgeschieden wird, und die vierte Precursor-Schicht zumindest ein Chalkogen, gewählt aus Schwefel und Selen, enthält und die vierte Precursor-Schicht dünner als die dritte Precursor-Schicht (5.2) ist.

5. Verfahren nach einem der Ansprüche 1 bis 4, bei welchem der Precursor-Schichtstapel (11) mehrmals nacheinander abgeschieden wird.

6. Verfahren nach einem der Ansprüche 1 bis 5, bei welchem das Gallium-Tiefenprofil von einer Oberfläche (9) des Verbindungshalbleiters (2) hin zu einer Grenzfläche (10) zum Körper (12) so ausgebildet wird, dass der Galliumgehalt an der Oberfläche (9) einen ersten Maximalwert hat, zur Grenzfläche (10) hin bis zu einem Minimalwert abnimmt und anschließend wieder zunimmt, und an der Grenzfläche (10) einen zweiten Maximalwert hat.

7. Verfahren nach Anspruch 6, bei welchem das Gallium-Tiefenprofil so ausgebildet wird, dass die absolute Änderung im Galliumgehalt zumindest über einen Teilbereich des Tiefenprofils wenigstens 20% beträgt.

8. Verfahren nach einem der Ansprüche 1 bis 7, bei welchem zur Herstellung eines quaternären Verbindungshalbleiters (2), gewählt aus Cu(In,Ga)Se₂ und Cu(In,Ga)S₂, die zweite Precursor-Schicht (6) hergestellt wird durch Abscheiden eines Chalkogens, gewählt aus Schwefel und Selen, auf der ersten Precursor-Schicht (5.1), wobei in dem zumindest einen, zumindest zeitweilig während der Wärmebehandlung zugeführten Prozessgas das gleiche Chalkogen, gewählt aus Schwefel und Selen, wie in der zweiten Precursor-Schicht (6) und/oder eine chalkogenhaltige Verbindung, gewählt aus einer schwefelhaltigen Verbindung und einer selenhaltigen Verbindung, mit dem gleichen Chalkogen wie in der zweiten Precursor-Schicht (6) enthalten ist.

9. Verfahren nach einem der Ansprüche 1 bis 7, bei welchem zur Herstellung eines pentanären Verbindungshalbleiters Cu(In,Ga)(S,Se)₂, bei welchem
- die zweite Precursor-Schicht (6) hergestellt wird durch Abscheiden eines Chalkogens, gewählt aus Schwefel und Selen, auf der ersten Precursor-Schicht (5.1), wobei in dem zumindest einen, zumindest zeitweilig während der Wärmebehandlung zugeführten Prozessgas das jeweils andere Chalkogen, gewählt aus Schwefel und Selen, wie in der zweiten Precursor-Schicht (6) und/oder eine chalkogenhaltige Verbindung, gewählt aus einer schwefelhaltigen Verbindung und einer selenhaltigen Verbindung, mit dem jeweils anderen Chalkogen wie in der zweiten Precursor-Schicht (6) enthalten ist;
oder
- die zweite Precursor-Schicht (6) hergestellt wird durch Abscheiden der Chalkogene Schwefel und Selen auf der ersten Precursor-Schicht (5.1), wobei in dem zumindest einen, zumindest zeitweilig während der Wärmebehandlung zugeführten Prozessgas Schwefel und/oder Selen und/oder eine schwefelhaltige Verbindung und/oder eine selenhaltige Verbindung enthalten ist.

10. Verfahren nach Anspruch 9, bei welchem durch das zumindest eine Prozessgas ein definiertes Schwefel-Tiefenprofil im pentanären Verbindungshalbleiter (2) ausgebildet wird und Kupfer, Indium und Gallium durch Sputtern und Selen durch Verdampfen abgeschieden wird.

11. Verfahren nach Anspruch 9 oder 10, bei welchem das Schwefel-Tiefenprofil von einer Oberfläche (9) des Verbindungshalbleiters (2) hin zu einer Grenzfläche (10) zum Körper (12) so ausgebildet wird, dass
- der Schwefelgehalt an der Oberfläche (9) einen Maximalwert hat, zur Grenzfläche (10) hin abnimmt und an der Grenzfläche (10) einen Minimalwert hat; oder
- der Schwefelgehalt an der Oberfläche (9) einen Minimalwert hat, zur Grenzfläche (10) hin zunimmt und an der Grenzfläche (10) einen Maximalwert hat; oder
- der Schwefelgehalt an der Oberfläche (9) einen ersten Maximalwert hat, zur Grenzfläche (10) hin bis zu einem Minimalwert abnimmt und anschließend wieder zunimmt, und an der Grenzfläche (10) einen zweiten Maximalwert hat; oder
- der Schwefelgehalt an der Oberfläche (9) einen ersten Minimalwert hat, zur Grenzfläche (10) hin bis zu einem Maximalwert zunimmt und anschließend wieder abnimmt, und an der Grenzfläche (10) einen zweiten Minimalwert hat.

12. Verfahren nach Anspruch 11, bei welchem das Schwefel-Tiefenprofil so ausgebildet wird, dass eine absolute Änderung des Schwefelgehalts zumindest über einen Teilbereich des Tiefenprofils wenigstens 20% beträgt.

13. Dünnschichtsolarzelle (20) mit einem auf einem Körper (12) angeordneten Absorber (2) aus einem quaternären Verbindungshalbleiter Cu(In,Ga)Se₂, einem quaternären Verbindungshalbleiter Cu(In,Ga)S₂ oder einem pentanären Verbindungshalbleiters Cu(In,Ga)(S,Se)₂, wobei der Verbindungshalbleiter (2) von einer Oberfläche (9) des Verbindungshalbleiters (2) zu einer Grenzfläche (10) zum Körper (12) hin ein definiertes Gallium-Tiefenprofil aufweist, wobei das Gallium-Tiefenprofil so ausgebildet ist, dass der Galliumgehalt an der Oberfläche (9) einen ersten Maximalwert hat, zur Grenzfläche (10) hin bis zu einem Minimalwert abnimmt und anschließend wieder zunimmt, und an der Grenzfläche (10) einen zweiten Maximalwert hat.

14. Dünnschichtsolarzelle (20) nach Anspruch 13, wobei der Verbindungshalbleiter (2) von einer Oberfläche (9) des Verbindungshalbleiters(2) zu einer Grenzfläche (10) zum Körper (12) hin ein definiertes Schwefel-Tiefenprofil aufweist.

15. Dünnschichtsolarzelle (20) nach Anspruch 14, wobei das Schwefel-Tiefenprofil so ausgebildet ist, dass
- der Schwefelgehalt an der Oberfläche (9) einen Maximalwert hat, zur Grenzfläche (10) hin abnimmt und an der Grenzfläche (10) einen Minimalwert hat; oder
- der Schwefelgehalt an der Oberfläche (9) einen Minimalwert hat, zur Grenzfläche (10) hin zunimmt und an der Grenzfläche (10) einen Maximalwert hat; oder
- der Schwefelgehalt an der Oberfläche (9) einen ersten Maximalwert hat, zur Grenzfläche (10) hin bis zu einem Minimalwert abnimmt und anschließend wieder zunimmt, und an der Grenzfläche (10) einen zweiten Maximalwert hat; oder
- der Schwefelgehalt an der Oberfläche (9) einen ersten Minimalwert hat, zur Grenzfläche (10) hin bis zu einem Maximalwert zunimmt und anschließend wieder abnimmt, und an der Grenzfläche (10) einen zweiten Minimalwert hat.

16. Verwendung des Verfahrens zum Herstellen eines Verbindungshalbleiters nach einem der Ansprüche 1 bis 12 zur Herstellung eines Absorbers (2) einer Dünnschichtsolarzelle (20) oder eines Dünnschichtsolarmoduls.

## Claims

1. Method for producing a compound semiconductor (2), which comprises the following steps:
- Producing at least one precursor layer stack (11), consisting of a first precursor layer (5.1), a second precursor layer (6), and a third precursor layer (5.2), wherein, in a first stage, the first precursor layer (5.1) is produced by depositing the metals copper, indium, and gallium onto a body (12), and, in a second stage, the second precursor layer (6) is produced by depositing at least one chalcogen, selected from sulfur and selenium, onto the first precursor layer (5.1), and, in a third stage, the third precursor layer (5.2) is produced by depositing the metals copper, indium, and gallium onto the second precursor layer (6);
- Heat treating the at least one precursor layer stack (11) in a process chamber (13) such that the metals of the first precursor layer (5.1), the at least one chalcogen of the second precursor layer (6), and the metals of the third precursor layer (5.2) are reactively converted to form the compound semiconductor (2).

2. Method according to claim 1, wherein at least one process gas is supplied to the process chamber (13) at least intermittently during the heat treatment of the at least one precursor layer stack (11) and at least one chalcogen, selected from sulfur and selenium, and/or at least one chalcogen-containing compound, selected from a sulfur-containing compound and a selenium-containing compound, is contained in the process gas.

3. Method according to claim 1 or 2, wherein
- the first precursor layer (5.1) and/or the third precursor layer (5.2) are deposited by sputtering of one or a plurality of individual layers from a copper-gallium alloy target and an indium target or from a copper-indium alloy target and a copper-gallium alloy target or from a copper-gallium-indium alloy target, and/or
- the second precursor layer (6) made of individual layers of the chalcogens sulfur and/or selenium is deposited.

4. Method according to one of claims 1 through 3, wherein a fourth precursor layer is deposited onto the third precursor layer (5.2), and the fourth precursor layer contains at least one chalcogen, selected from sulfur and selenium, and the fourth precursor layer is thinner than the third precursor layer (5.2).

5. Method according to one of claims 1 through 4, wherein the precursor layer stack (11) is deposited several times in succession.

6. Method according to one of claims 1 through 5, wherein the gallium depth profile from a surface (9) of the compound semiconductor (2) to an interface (10) with the body (12) is configured such that the gallium content has a first maximum value at the surface (9), decreases toward the interface (10) down to a minimum value, and then increases again, and has a second maximum value at the interface (10).

7. Method according to claim 6, wherein the gallium depth profile is configured such that the absolute change in the gallium content is at least 20% at least over a portion of the depth profile.

8. Method according to one of claims 1 through 7, wherein for producing a quaternary compound semiconductor (2), selected from Cu(In,Ga)Se₂ and Cu(In,Ga)S₂, the second precursor layer (6) is produced by depositing a chalcogen, selected from sulfur and selenium, onto the first precursor layer (5.1), wherein the same chalcogen, selected from sulfur and selenium, as in the second precursor layer (6) and/or a chalcogen-containing compound, selected from a sulfur-containing compound and a selenium-containing compound, with the same chalcogen as in the second precursor layer (6), is contained in the at least one process gas supplied at least intermittently during the heat treatment.

9. Method according to one of claims 1 through 7, wherein for producing of a pentanary compound semiconductor Cu(In,Ga)(S,Se)₂, wherein
- the second precursor layer (6) is produced by depositing one chalcogen, selected from sulfur and selenium, onto the first precursor layer (5.1), wherein the respective other chalcogen, selected from sulfur and selenium, as in the second precursor layer (6) and/or a chalcogen-containing compound, selected from a sulfur-containing compound and a selenium-containing compound, with the respective other chalcogen as in the second precursor layer (6), is contained in the at least one process gas supplied at least intermittently during the heat treatment;
or
- the second precursor layer (6) is produced by depositing the chalcogens sulfur and selenium onto the first precursor layer (5.1), wherein sulfur and/or selenium and/or a sulfur-containing compound and/or a selenium-containing compound is contained in the at least one process gas supplied at least intermittently during the heat treatment.

10. Method according to claim 9, wherein a defined sulfur depth profile is formed in the pentanary compound semiconductor (2) by the at least one process gas, and copper, indium and gallium are deposited by sputtering, and selenium is deposited by vapor deposition.

11. Method according to claim 9 or 10, wherein the sulfur depth profile from one surface (9) of the compound semiconductor (2) to an interface (10) with the body (12) is configured such that
- the sulfur content has a maximum value at the surface (9), decreases toward the interface (10), and has a minimum value at the interface (10); or
- the sulfur content has a minimum value at the surface (9), increases toward the interface (10), and has a maximum value at the interface (10); or
- the sulfur content has a first maximum value at the surface (9), decreases down to a minimum value toward the interface (10), and then increases again, and has a second maximum value at the interface (10); or
- the sulfur content has a first minimum value at the surface (9), increases toward the interface (10) up to a maximum value, and then decreases again, and has a second minimum value at the interface (10).

12. Method according to claim 11, wherein the sulfur depth profile is configured such that an absolute change of the sulfur content is at least 20% at least over a portion of the depth profile.

13. Thin-film solar cell (20) having an absorber (2) made of a quaternary compound semiconductor Cu(In,Ga)Se₂, a quaternary compound semiconductor Cu(In,Ga)S₂, or a pentanary compound semiconductor Cu(In,Ga)(S,Se)₂ arranged on a body (12), wherein the compound semiconductor (2) has a defined gallium depth profile from one surface (9) of the compound semiconductor (2) to an interface (10) with the body (12), wherein the gallium depth profile is configured such that the gallium content has a first maximum value at the surface (9), decreases down to a minimum value toward the interface (10) and then increases again, and has a second maximum value at the interface (10).

14. Thin-film solar cell (20) according to claim 12 or 13, wherein the compound semiconductor (2) has a defined sulfur depth profile from one surface (9) of the compound semiconductor (2) to an interface (10) with the body (12).

15. Thin-film solar cell (20) according to claim 14, wherein the sulfur depth profile is configured such that
- the sulfur content has a maximum value at the surface (9), decreases toward the interface (10), and has a minimum value at the interface (10); or
- the sulfur content has a minimum value at the surface (9), increases toward the interface (10), and has a maximum value at the interface (10); or
- the sulfur content has a first maximum value at the surface (9), decreases down to a minimum value toward the interface (10) and then increases again, and has a second maximum value at the interface (10); or
- the sulfur content has a first minimum value at the surface (9), increases up to a maximum value toward the interface (10), and has a second minimum value at the interface (10).

16. Use of the method for producing a compound semiconductor according to one of claims 1 through 12 for producing an absorber (2) of a thin-film solar cell (20) or a thin-film solar module.

## Revendications

1. Procédé pour la production d'un semi-conducteur composé (2) qui comprend les étapes suivantes :
- production d'au moins un empilement précurseur (11), consistant en une première couche précurseur (5.1), une deuxième couche précurseur (6) et une troisième couche précurseur (5.2) où dans une première étape la première couche précurseur (5.1) est produite en déposant les métaux cuivre, indium et gallium sur un corps (12), et dans une première étape la deuxième couche précurseur (6) est produite en déposant au moins un chalcogène, choisi parmi le soufre et le sélénium, sur la première couche précurseur (5.1) et dans une troisième étape la troisième couche précurseur (5.2) est produite en déposant les métaux cuivre, indium et gallium sur la deuxième couche précurseur (6) ;
- traitement thermique dudit au moins un empilement précurseur (11) dans une chambre de traitement (13) de manière à transformer de manière réactive les métaux de la première couche précurseur (5.1), ledit au moins un chalcogène de la deuxième couche précurseur (6) et les métaux de la troisième couche précurseur (5.2) en semi-conducteur composé (2).

2. Procédé selon la revendication 1, dans lequel au moins un gaz de procédé est introduit au moins temporairement dans la chambre de traitement 13) pendant le traitement thermique dudit au moins un empilement précurseur (11) et le gaz de procédé contient au moins un chalcogène, choisi parmi le soufre et le sélénium, ou au moins un composé contenant un chalcogène choisi parmi un composé contenant du soufre et est un composé contenant du sélénium.

3. Procédé selon la revendication 1 ou 2, dans lequel
- la première couche précurseur (5.1) et/ou la troisième couche précurseur (5.2) sont déposées par la pulvérisation d'une ou plusieurs couches individuelles à partir d'une cible d'un alliage cuivre-gallium et d'une cible d'Indium ou à partir d'une cible d'un alliage cuivre-Indium et d'une cible d'un alliage cuivre-gallium ou à partir d'une cible d'un alliage cuivre-Indium-gallium, et/ou
- la deuxième couche précurseur (6) est déposée à partir de couches individuelles des chalcogènes soufre et/ou sélénium.

4. Procédé selon l'une des revendications 1 à 3, dans lequel une quatrième couche précurseur est déposée sur la troisième couche précurseur (5.2) et la quatrième couche précurseur contient au moins un chalcogène choisi parmi le soufre et le sélénium, et la quatrième couche précurseur est plus fine que la troisième couche précurseur (5.2).

5. Procédé selon l'une des revendications 1 à 4, dans lequel l'empilement précurseur (11) est déposée plusieurs fois de suite.

6. Procédé selon l'une des revendications 1 à 5, dans lequel le profil de profondeur du gallium à partir d'une surface (9) du semi-conducteur composé (2) vers une interface (10) vers le corps (12) est constitué de telle manière, que la teneur en gallium a une première valeur maximale à la surface (9), diminue vers l'interface (10) à une valeur minimale pour ensuite remonter à une deuxième valeur maximale à l'interface (10).

7. Procédé selon la revendication 6, dans lequel le profil de profondeur du gallium est conçu de telle manière que la variation absolue dans la teneur en gallium est au moins 20% sur au moins une partie du profil de profondeur.

8. Procédé selon une des revendications 1 à 7, dans lequel pour la production d'un semi-conducteur composé (2) quaternaire, choisi parmi Cu (In, Ga) Se₂ et Cu (In, Ga) S₂, la deuxième couche précurseur (6) est produite par le dépôt d'un chalcogène, choisi parmi le soufre et le sélénium, sur la première couche précurseur (5.1), où ledit au moins un gaz de procédé, introduit au moins temporairement pendant le traitement thermique, contient le même chalcogène, choisi parmi le soufre et le sélénium, que celui de la deuxième couche précurseur (6), et/ou un composé contenant un chalcogène, choisi parmi un composé contenant du soufre et un composé contenant du sélénium avec le même chalcogène que celui de la deuxième couche précurseur (6)

9. Procédé selon une des revendications 1 à 7, dans lequel pour la production d'un semi-conducteur composé pentanaire Cu(In, Ga) (S, Se)₂, dans lequel
- la deuxième couche précurseur (6) est produite par le dépôt d'un chalcogène, choisi parmi le soufre et le sélénium, sur la première couche précurseur (5.1), où ledit au moins un gaz de procédé, introduit au moins temporairement pendant le traitement thermique, contient respectivement l'autre chalcogène, choisi parmi le soufre et le sélénium, que celui de la deuxième couche précurseur (6), et/ou un composé contenant un chalcogène, choisi parmi un composé contenant du soufre et un composé contenant du sélénium avec l'autre chalcogène que celui de la deuxième couche précurseur (6) ;
ou
- la deuxième couche précurseur (6) est produite par le dépôt des chalcogènes soufre et sélénium sur la première couche précurseur (5.1), où ledit au moins un gaz de procédé, introduit au moins temporairement pendant le procédé de traitement thermique, contient du soufre ou du sélénium ou un composé contenant du soufre et/ou un composé contenant du sélénium.

10. Procédé selon la revendication 9, qui, par ledit au moins un gaz de procédé un profil de profondeur défini est conçu dans le semi-conducteur composé (2) pentanaire et du cuivre, de l'indium et du gallium sont déposés par pulvérisation et su sélénium par vaporisation.

11. Procédé selon la revendication 9 ou 10, dans lequel le profil de profondeur du soufre à partir d'une surface (9) du semi-conducteur composé (2) vers une interface (10) vers le corps (12) est conçue de telle manière, que
- la teneur en soufre a une valeur maximale à la surface (9), diminue vers l'interface (10) et atteint une valeur minimale à l'interface (10) ; ou
- la teneur en soufre a une valeur minimale à la surface (9), remonte vers l'interface (10) et atteint une valeur maximale à l'interface (10) ; ou
- la teneur en soufre a une première valeur maximale à la surface (9) et diminue vers l'interface (10) à une valeur minimale pour ensuite remonter a une deuxième valeur maximale à l'interface (10) ; ou
- la teneur en soufre a une première valeur minimale à la surface (9), remonte vers l'interface (10) à une valeur maximale pour ensuite diminuer à l'interface (10) a une deuxième valeur minimale.

12. Procédé selon la revendication 11, dans lequel le profil de profondeur du soufre est conçu de telle manière, qu'un changement absolu de la teneur en soufre est-au moins 20% pour une partie du profil de profondeur.

13. Cellule solaire à couches minces (20) avec un absorbeur (2) disposé sur un corps (12) d'un semi-conducteur composé quaternaire Cu (In, Ga) Se₂, un semi-conducteur composé quaternaire Cu (In, Ga) S₂ ou un semi-conducteur composé pentanaire Cu(In, Ga) (S, Se)₂, où le semi-conducteur composé (2) présente un profil de profondeur de gallium définie à partir de la surface (9) du semi-conducteur composé (2) vers une interface (10) vers le corps (12), où le profil de profondeur de gallium est conçu, de telle manière que la teneur en gallium à la surface (9) a une première valeur maximale, diminue vers l'interface (10) à une valeur minimale pour ensuite remonter a une deuxième valeur maximale à l'interface (10).

14. Cellule solaire à couches minces (20), selon la revendication 13, où le semi-conducteur composé (2) présente un profil de profondeur de soufre définie à partir de la surface (9) du semi-conducteur composé (2) vers une interface (10) vers le corps (12).

15. Cellule solaire à couches minces (20) selon la revendication 14, où le profil de profondeur du soufre est conçu de telle manière que
- la teneur en soufre a une valeur maximale à la surface (9), diminue vers l'interface (10) et atteint une valeur minimale à l'interface (10) ; ou
la teneur en soufre a une valeur minimale à la surface (9), remonte vers l'interface (10) et atteint une valeur maximale à l'interface (10) ; ou
- la teneur en soufre a une première valeur maximale à la surface (9) et diminue vers l'interface (10) à une valeur minimale pour ensuite remonter a une deuxième valeur maximale à l'interface (10) ; ou
- la teneur en soufre a une valeur première minimale à la surface (9), remonte vers l'interface (10) à une valeur maximale pour ensuite diminuer à l'interface (10) a une deuxième valeur minimale.

16. Utilisation du procédé de fabrication d'un semi-conducteur composé selon l'une des revendications 1 à 12 pour la production d'un absorbeur (2) d'une cellule solaire à couches minces (20) ou un module solaire a couches minces.
